# EUROPEAN PATENT APPLICATION

(11) **EP 4 830 910 A1**
(43) Date of publication of application: **28.10.2026**
(21) Application number: 26162386.2
(22) Date of filing: 04.03.2026
(51) Int. Cl.: B32B 3/26, B32B 7/00, B32B 7/06, B32B 7/12, B32B 27/08, B32B 27/28, B32B 27/30, B32B 27/34, B32B 27/36, G06F 1/16, H10K 59/12, H10K 77/10, H10K 102/00

(54) **RELEASE FILM, DISPLAY DEVICE, AND ELECTRONIC DEVICE**

(30) Priority: 24.04.2025 KR 20250053808
(71) Applicant: Samsung Display Co., Ltd., Yongin-si, Gyeonggi-do 17113 (KR)
(72) Inventor: JO, Hyunseong, 17113 Yongin-si (KR); KIM, Donghyeon, 17113 Yongin-si (KR); PARK, Changmin, 17113 Yongin-si (KR); LEE, Hosang, 17113 Yongin-si (KR)
(74) Representative: Marks & Clerk LLP

(57) **Abstract**

A release film includes a first sub-layer and a second sub-layer disposed on the first sub-layer. The first sub-layer includes a first side portion, a second side portion positioned in a first direction from the first side portion, and a central portion between the first side portion and the second side portion. The second sub-layer includes first extension patterns disposed on the central portion of the first sub-layer, each extending in the first direction, and spaced apart from each other in a second direction crossing the first direction, and a second extension pattern disposed on the first side portion of the first sub-layer and extending in the second direction.

## Description

### BACKGROUND

### 1. Field

Embodiments relate to a release film used in a manufacture of a display device, and a display device and an electronic device manufactured using the release film. More particularly, embodiments relate to a release film used in a manufacture of a flexible display device, and a display device and an electronic device manufactured using the release film.

### 2. Description of the Related Art

With the development of information technology, the importance of a display device, which is a connection medium between a user and information, has been highlighted. For example, the use of display devices such as liquid crystal display (LCD) device, organic light emitting display (OLED) device, plasma display panel (PDP) device, quantum dot display device, or the like is increasing.

Recently, flexible display devices that can be bent are widely used in various fields. For example, flexible display devices, such as slidable display devices, foldable display devices, or the like are being used in various fields.

### SUMMARY

Embodiments provide a release film capable of improving an yield of a display device and an electronic device.

Embodiments also provide a display device with improved yield.

Embodiments also provide an electronic device with improved yield.

Additional features of the embodiments will be set forth in the description which follows, and in part will be apparent from the description, or may be learned by practice of the embodiments.

A release film according to an embodiment includes a first sub-layer and a second sub-layer disposed on the first sub-layer. In such an embodiment, the first sub-layer includes a first side portion, a second side portion positioned in a first direction from the first side portion, and a central portion between the first side portion and the second side portion. In such an embodiment, the second sub-layer includes first extension patterns disposed on the central portion of the first sub-layer, each extending in the first direction, and spaced apart from each other in a second direction crossing the first direction, and a second extension pattern disposed on the first side portion of the first sub-layer and extending in the second direction.

In an embodiment, the first extension patterns may be disposed on the second side portion of the first sub-layer.

In an embodiment, first openings may be defined in the second sub-layer. Each of the first openings may be defined by two adjacent first extension patterns among the first extension patterns.

In an embodiment, each of the first openings may extend in the first direction, and the first openings may be arranged in the second direction.

In an embodiment, the first extension patterns may be spaced apart from the second extension pattern in the first direction.

In an embodiment, a second opening connected to the first openings may be defined in the second sub-layer. In such an embodiment, the second opening may be defined by the first extension patterns and the second extension pattern.

In an embodiment, the second opening may extend in the second direction.

In an embodiment, the second sub-layer further may include a third extension pattern disposed on the second side portion of the first sub-layer, spaced apart from the first extension patterns in the first direction, and extending in the second direction.

In an embodiment, a third opening connected to the first openings may be defined in the second sub-layer. In such an embodiment, the third opening may be defined by the first extension patterns and the third extension pattern.

In an embodiment, the first extension patterns may be integrally connected to the second extension pattern.

In an embodiment, the release film may further include a masking pattern disposed on an end portion of the second extension pattern, where the masking pattern may include a first surface which contacts the end portion of the second extension pattern and a second surface opposite to the first surface. In such an embodiment, the second surface of the masking pattern may be non-adhesive.

In an embodiment, a width of the central portion of the first sub-layer in the first direction may be greater than each of a width of the first side portion of the first sub-layer in the first direction and a width of the second side portion of the first sub-layer in the first direction.

A display device according to an embodiment includes a display panel, a support plate disposed under the display panel, and a release film disposed under the support plate. In such an embodiment, the support plate includes a first area, a second area positioned in a first direction from the first area, and a third area between the first area and the second area. In such an embodiment, holes each extending in a second direction crossing the first direction are defined in the third area. In such an embodiment, the release film includes a first sub-layer and a second sub-layer disposed between the first sub-layer and the support plate. In such an embodiment, the first sub-layer includes a first side portion under the first area of the support plate, a second side portion under the second area of the support plate, and a central portion under the third area of the support plate. In such an embodiment, the second sub-layer includes first extension patterns disposed on the central portion of the first sub-layer, each extending in the first direction, and spaced apart from each other in the second direction, and a second extension pattern disposed on the first side portion of the first sub-layer and extending in the second direction.

In an embodiment, the first extension patterns and the second extension patterns may directly contact the support plate.

In an embodiment, in a plan view, a size of the release film may be greater than a size of the support plate. In such an embodiment, a length of the second extension pattern in the second direction may be greater than a width of the support plate in the second direction.

In an embodiment, a width of each of the first extension patterns in the second direction may be less than a length of each of the holes of the support plate in the second direction.

In an embodiment, the release film further may include a masking pattern disposed between an end portion of the second extension pattern and the support plate, where the masking pattern may include a first surface which contacts the end portion of the second extension pattern and a second surface opposite to the first surface. In such an embodiment, the second surface of the masking pattern may be non-adhesive.

In an embodiment, the masking pattern may include a first portion which does not overlap the support plate in a plan view, and a second portion which overlaps the support plate in the plan view. In such an embodiment, the second surface of the second portion of the masking pattern may directly contact the support plate.

In an embodiment, the display device may further include an adhesive layer disposed between the display panel and the support plate and overlapping all of the holes in a plan view.

An electronic device according to an embodiment includes a display device which displays an image and a processor which provides an image data signal and an input control signal to the display device. In such an embodiment, the display device includes a display panel, a support plate disposed under the display panel, and an adhesive layer disposed between the display panel and the support plate. In such an embodiment, holes each extending in one direction are defined in the support plate. In such an embodiment, the adhesive layer overlaps all of the holes of the support plate in a plan view.

At least some of the above and other features of the invention are set out in the claims.

According to embodiments, the release film attached to the support plate may provide passages through which air inside the holes defined in the support plate can move during a lamination process of the support plate and a display panel assembly. Accordingly, during the lamination process of the support plate and the display panel assembly, bending of the support plate and the display panel may be effectively prevented or substantially reduced. In addition, the release film may have a structure that allows the entire release film to be easily separated from the support plate when the release film is separated and removed from the support plate as desired. Therefore, the yield of the display device and the electronic device may be improved.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the invention.
FIGS. 1A and 1B are perspective views schematically illustrating an electronic device according to an embodiment.
FIG. 2 is a cross-sectional view schematically illustrating the electronic device of FIGS. 1A and 1B.
FIG. 3 is a perspective view schematically illustrating an electronic device according to an embodiment.
FIG. 4 is a cross-sectional view illustrating a display device according to an embodiment.
FIG. 5 is a cross-sectional view illustrating a display panel according to an embodiment.
FIG. 6 is a bottom view illustrating a support plate according to an embodiment.
FIG. 7 is a cross-sectional view illustrating a display device according to an embodiment.
FIGS. 8 and 9 are bottom views illustrating a support plate and a release film according to an embodiment.
FIG. 10 is a cross-sectional view taken along line I-I' of FIG. 8.
FIG. 11 is a cross-sectional view taken along line II-II' of FIG. 8.
FIG. 12 is a cross-sectional view taken along line III-III' of FIG. 8.
FIGS. 13A and 13B are views schematically illustrating a method of manufacturing a display device according to an embodiment.
FIG. 14 is a perspective view illustrating a portion of a release film and a portion of a support plate according to an embodiment.
FIG. 15 is a bottom view illustrating a support plate and a release film according to an embodiment.
FIG. 16 is a cross-sectional view taken along line IV-IV' of FIG. 15.
FIG. 17 is a bottom view illustrating a support plate and a release film according to an embodiment.
FIG. 18 is a cross-sectional view taken along line V-V' of FIG. 17.
FIG. 19 is a bottom view illustrating a support plate and a release film according to an embodiment.
FIG. 20 is a cross-sectional view taken along line VI-VI' of FIG. 19.
FIG. 21 is a cross-sectional view taken along line VII-VII' of FIG. 19.
FIG. 22 is a bottom view illustrating a support plate and a release film according to an embodiment.
FIG 23 is a cross-sectional view taken along line VIII-VIII' of FIG 22.
FIG. 24 is a block diagram illustrating an electronic device according to an embodiment.
FIG. 25 is a schematic diagram illustrating electronic devices according to various embodiments.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

It will be understood that when an element is referred to as being "connected" or "coupled" to another element, it can be directly connected or coupled to the other element or intervening element(s) may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described in detail with reference to the accompanying drawings. The same reference numerals are used for the same components in the drawings, and any repetitive detailed descriptions of the same components will be omitted or simplified.

An electronic device according to embodiments may be a device that is activated according to an electrical signal. For example, the electronic device may be a smart phone, a mobile phone, a smart watch, a game console, a camera, a laptop computer, a tablet personal computer (PC), a television, a computer monitor, a vehicle monitor, an external billboard, or the like.

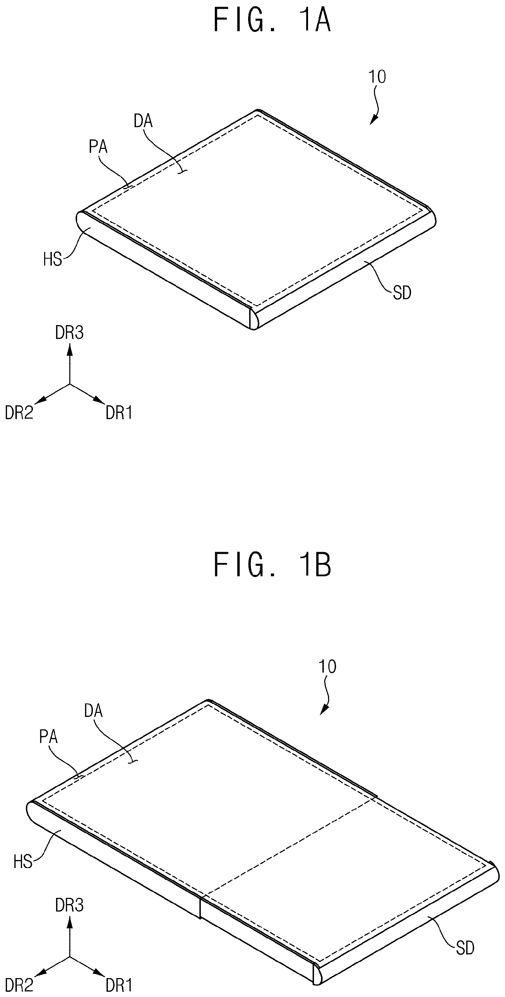

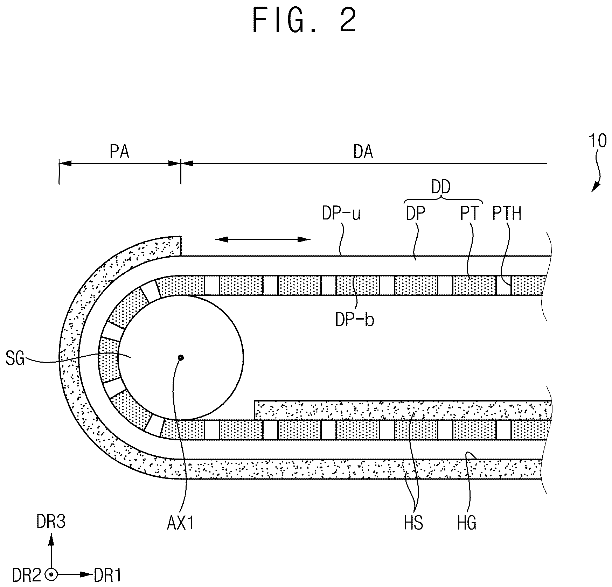

FIGS. 1A and 1B are perspective views schematically illustrating an electronic device according to an embodiment. FIG. 2 is a cross-sectional view schematically illustrating the electronic device of FIGS. 1A and 1B.

Referring to FIGS. 1A, 1B, and 2, in an embodiment, the electronic device 10 may include a display area DA and a peripheral area PA. The display area DA may be an area that includes pixels and displays an image.

The peripheral area PA may be positioned around the display area DA. The peripheral area PA may surround at least a portion of the display area DA in a plan view. In an embodiment, the peripheral area PA may be an area that does not include pixels and does not display an image. In another embodiment, at least a portion of the peripheral area PA may include pixels and may display an image.

In an embodiment, the electronic device 10 may be a slidable electronic device in which an area of the display area DA increases or decreases by a sliding operation. In an embodiment, for example, as illustrated in FIGS. 1A and 1B , the electronic device 10 may slide out in a first direction DR1, and may slide in in a direction opposite to the first direction DR1. In such an embodiment, as illustrated in FIG. 2 , the electronic device 10 may slide with respect to a reference axis AX1 that is parallel to a second direction DR2 crossing the first direction DR1. The second direction DR2 may be perpendicular to the first direction DR1. When the electronic device 10 slides in, the area of the display area DA may decrease (see FIG. 1A), and when the electronic device 10 slides out, the area of the display area DA may increase (see FIG. 1B).

In an embodiment, as shown in FIG. 2, the electronic device 10 may include a display device DD, a housing HS, a slider SD, and a sliding guide SG.

The display device DD may be a flexible display device that is bendable. The display device DD includes a display panel DP and a support plate PT. The pixels may be disposed in the display area DA of the display panel DP. Driving circuits, wires, or the like for driving the pixels may be disposed in the peripheral area PA of the display panel DP.

The display panel DP may include a first surface DP-u and a second surface DP-b opposite to the first surface DP-u. In an embodiment, the display panel DP may display the image in a third direction DR3 through the first surface DP-u. The first surface DP-u may be a display surface.

Hereinafter, the third direction DR3, which is the direction in which the display panel DP (or the electronic device 10 including the display panel DP) displays an image, may be referred to as an upper direction, and a direction opposite to the third direction DR3 may be referred to as a lower direction. In an embodiment, for example, the first surface DP-u may be an upper surface of the display panel DP, and the second surface DP-b may be a lower surface of the display panel DP.

The support plate PT may be disposed on the second surface DP-b of the display panel DP to support the display panel DP. When the display device DD slides, the support plate PT may move together with the display panel DP.

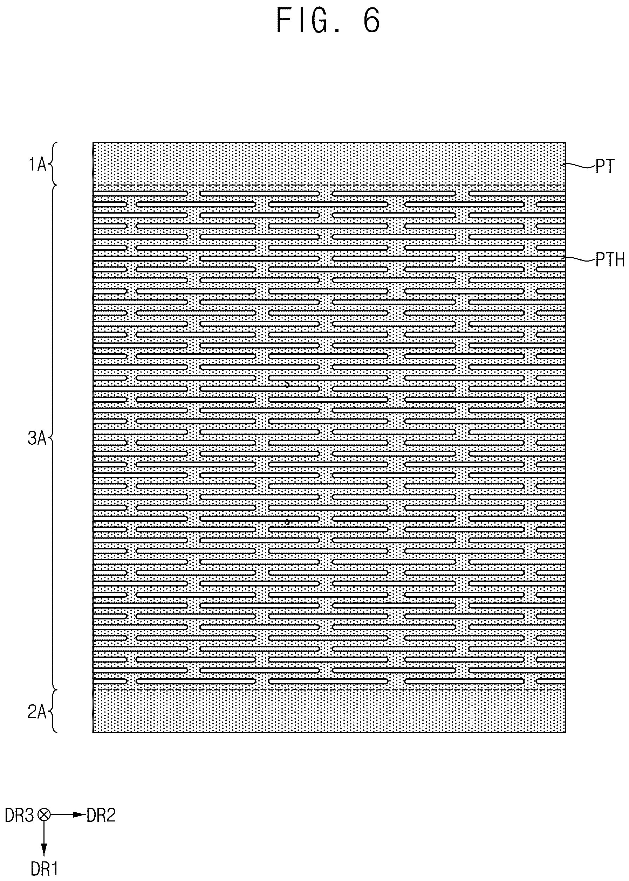

The support plate PT may include a relatively rigid material. The rigidity of the support plate PT may be greater than the rigidity of the display panel DP. In order for the support plate PT to be bendable, holes PTH each extending in the second direction DR2 may be defined in the support plate PT. This will be described in detail later with reference to FIG. 6.

The display device DD may be assembled to the housing HS and the slider SD. In an embodiment, for example, a first end portion of the display device DD may be connected to the slider SD, and a second end portion of the display device DD may be inserted between the housing HS and the sliding guide SG and accommodated in a groove HG of the housing HS. The display device DD may slide together with the slider SD that slides in the first direction DR1 and the direction opposite to the first direction DR1. However, this is an example and the invention is not limited thereto.

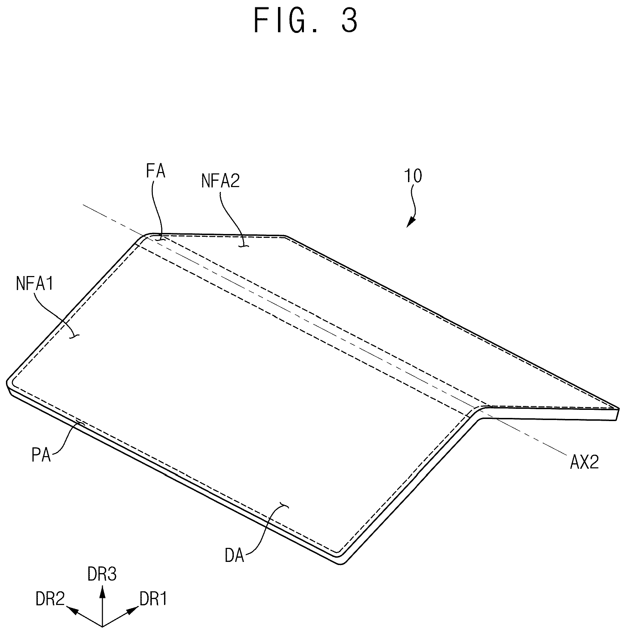

FIG. 3 is a perspective view schematically illustrating an electronic device according to an embodiment.

Referring to FIG. 3, in an embodiment, the electronic device 10 may be a foldable electronic device. The electronic device 10 may include the display area DA and the peripheral area PA.

In an embodiment, the electronic device 10 may include a first non-folding area NFA1, a second non-folding area NFA2, and a folding area FA. The second non-folding area NFA2 may be positioned in the first direction DR1 from the first non-folding area NFA1. The folding area FA may be positioned between the first non-folding area NFA1 and the second non-folding area NFA2. The folding area FA may be an area that is folded with respect to a folding axis AX2 parallel to the second direction DR2 when the electronic device 10 is folded, and the first non-folding area NFA1 and the second non-folding area NFA2 may be areas that are not folded when the electronic device 10 is folded.

In an embodiment, as illustrated in FIG. 3, the electronic device 10 may be folded or foldable in an out-folding manner such that portions of a lower surface of the electronic device 10 face each other. In such an embodiment, in the folded state, an upper surface (e.g., the display surface) of the electronic device 10 may be disposed on the outside of the electronic device 10. In another embodiment, unlike as illustrated in the drawing, the electronic device 10 may be folded or foldable in an in-folding manner such that portions of the upper surface (e.g., the display surface) of the electronic device 10 face each other. In such an embodiment, in the folded state, the lower surface of the electronic device 10 may be disposed on the outside of the electronic device 10.

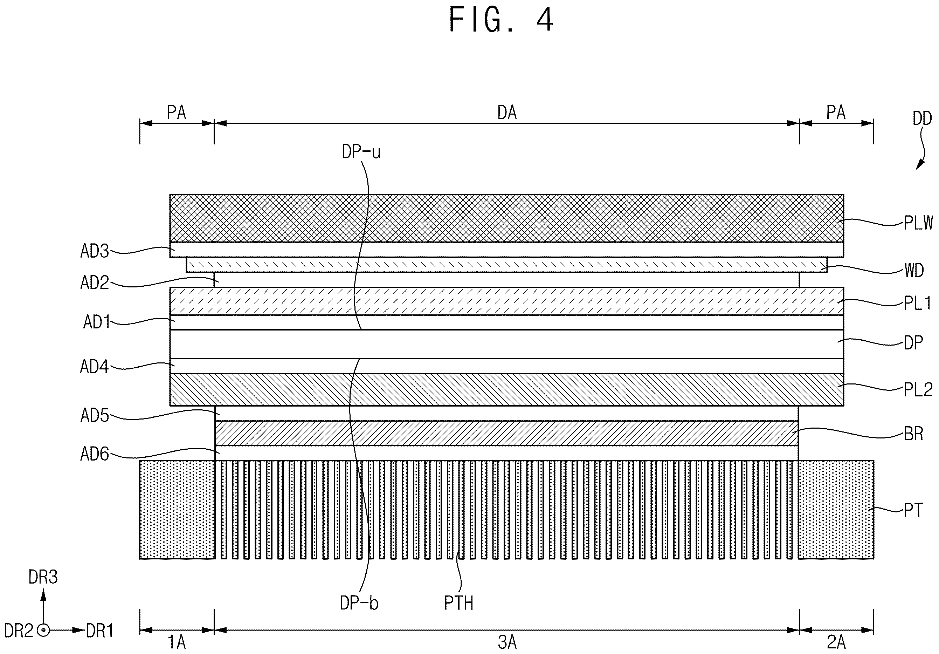

FIG. 4 is a cross-sectional view illustrating a display device according to an embodiment.

The display device DD of FIG. 4 may be the display device DD included in the slidable electronic device 10 of FIGS. 1A, 1B, and 2. The display device DD of FIG. 4 may be the display device DD included in the foldable electronic device 10 of FIG. 3.

Referring to FIG. 4, in an embodiment, the display device DD may include the display panel DP, a first protective layer PL1, a window WD, a window protective layer PLW, a second protective layer PL2, a barrier layer BR, and the support plate PT.

Each of the components included in the display device DD may be attached to each other by adhesive layers AD1, AD2, AD3, AD4, AD5, and AD6. In an embodiment, each of the adhesive layers AD1, AD2, AD3, AD4, AD5, and AD6 may be a pressure sensitive adhesive (PSA). Alternatively, each of the adhesive layers AD1, AD2, AD3, AD4, AD5, and AD6 may be an optically clear adhesive (OCA) or an optically clear resin (OCR). The adhesive layers AD1, AD2, AD3, AD4, AD5, and AD6 may be the same as each other or different from each other.

The display panel DP may include the display area DA and the peripheral area PA. The display panel DP may include the pixels disposed in the display area DA.

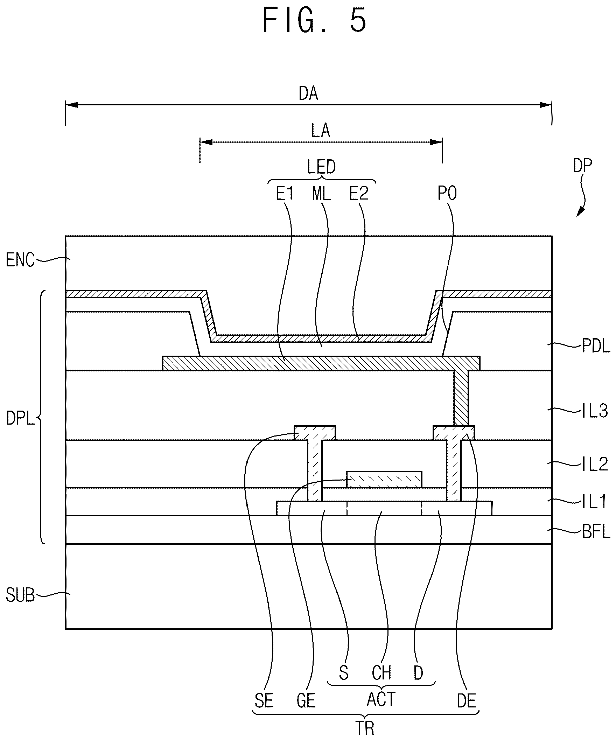

FIG. 5 is a cross-sectional view illustrating a display panel according to an embodiment.

In an embodiment, the display panel DP may include a substrate SUB, a display layer DPL, and an encapsulation layer ENC.

The substrate SUB may form a base for the display panel DP. The substrate SUB may be an insulating substrate including or formed of a transparent or a non-transparent material. The substrate SUB may be flexible. In an embodiment, the substrate SUB may have a structure in which at least one resin layer and at least one inorganic barrier layer are alternately stacked, but the invention is not limited thereto.

The display layer DPL may be disposed in the display area DA on the substrate SUB. In an embodiment, the display layer DPL may include a buffer layer BFL, the pixels, first to third insulating layers IL1, IL2, and IL3, and a pixel defining layer PDL. Each of the pixels may include a pixel circuit and a light emitting element LED. The pixel circuit may include at least one transistor TR and at least one capacitor.

The buffer layer BFL may be disposed on the substrate SUB. The buffer layer BFL may prevent or reduce impurities, such as oxygen or moisture, from penetrating into an upper portion of the substrate SUB through the substrate SUB. The buffer layer BFL may include an inorganic material, such as a silicon compound, a metal oxide, or the like. In an embodiment, for example, the buffer layer BFL may include silicon oxide (SiOₓ), silicon nitride (SiNₓ), silicon oxynitride (SiOₓN_{y}), aluminium oxide (AlOₓ), aluminium nitride (AlNₓ), tantalum oxide (TaOₓ), hafnium oxide (HfOₓ), zirconium oxide (ZrOₓ), titanium oxide (TiOₓ), or other compounds. These may be used alone or in combination with each other. The buffer layer BFL may have a single layer structure or a multi-layer structure including a plurality of insulating layers.

The transistor TR may be disposed on the buffer layer BFL. The transistor TR may include an active layer ACT, a gate electrode GE, a first contact electrode SE, and a second contact electrode DE.

The active layer ACT may be disposed on the buffer layer BFL. The active layer ACT may include an oxide semiconductor, a silicon semiconductor, an organic semiconductor, or the like. In an embodiment, for example, the oxide semiconductor may include at least one selected from oxides of indium (In), gallium (Ga), tin (Sn), zirconium (Zr), vanadium (V), hafnium (Hf), cadmium (Cd), germanium (Ge), chromium (Cr), titanium (Ti), and zinc (Zn). The silicon semiconductor may include an amorphous silicon, a polycrystalline silicon, or the like. The active layer ACT may include a first contact area S, a second contact area D, and a channel area CH located between the first contact area S and the second contact area D. Each of the first contact area S and the second contact area D may have higher conductivity than a conductivity of the channel area CH.

The first insulating layer IL1 may be disposed on the active layer ACT. The first insulating layer IL1 may cover the active layer ACT on the buffer layer BFL. The first insulating layer IL1 may include an inorganic insulating material.

The gate electrode GE may be disposed on the first insulating layer IL1. The gate electrode GE may overlap the channel area CH of the active layer ACT. The gate electrode GE may include a conductive material, such as a metal, an alloy, a conductive metal nitride, a conductive metal oxide, a transparent conductive material, or the like. In an embodiment, for example, the gate electrode GE may include gold (Au), silver (Ag), aluminium (Al), platinum (Pt), nickel (Ni), titanium (Ti), palladium (Pd), magnesium (Mg), calcium (Ca), lithium (Li), chromium (Cr), tantalum (Ta), tungsten (W), copper (Cu), molybdenum (Mo), scandium (Sc), neodymium (Nd), iridium (Ir), alloys containing aluminium, alloys containing silver, alloys containing copper, alloys containing molybdenum, aluminium nitride (AlNₓ), tungsten nitride (WNₓ), titanium nitride (TiNₓ), chromium nitride (CrNₓ), tantalum nitride (TaNₓ), strontium ruthenium oxide (SrRuOₓ), zinc oxide (ZnOₓ), indium tin oxide (ITO), tin oxide (SnOₓ), indium oxide (InOₓ), gallium oxide (GaOₓ), indium zinc oxide (IZO), or the like. These may be used alone or in combination with each other. The gate electrode GE may have a single layer structure or a multi-layer structure including a plurality of conductive layers.

The second insulating layer IL2 may be disposed on the gate electrode GE. The second insulating layer IL2 may cover the gate electrode GE on the first insulating layer IL1. The second insulating layer IL2 may include an inorganic insulating material.

The first contact electrode SE and the second contact electrode DE may be disposed on the second insulating layer IL2. The first contact electrode SE and the second contact electrode DE may be connected to the first contact area S and the second contact area D of the active layer ACT, respectively. Each of the first contact electrode SE and the second contact electrode DE may include a conductive material.

The third insulating layer IL3 may be disposed on the first contact electrode SE and the second contact electrode DE. The third insulating layer IL3 may include an organic insulating material. In an embodiment, for example, the third insulating layer IL3 may include a photoresist, a polyacryl-based resin, a polyimide-based resin, a polyamide-based resin, a siloxane-based resin, an acrylic resin, an epoxy-based resin, or the like. These may be used alone or in combination with each other.

The light emitting element LED may be disposed on the third insulating layer IL3. The light emitting element LED may include a first electrode E1, an intermediate layer ML, and a second electrode E2.

The first electrode E1 may be disposed on the third insulating layer IL3. The first electrode E1 may include a conductive material. The first electrode E1 may be connected to the second contact electrode DE through a contact hole defined or formed in the third insulating layer IL3. Accordingly, the first electrode E1 may be electrically connected to the transistor TR. In an embodiment, for example, the first electrode E1 may be an anode of the light emitting element LED.

The pixel defining layer PDL may be disposed on the first electrode E1. The pixel defining layer PDL may cover a peripheral portion of the first electrode E1 and may define a pixel opening PO that exposes a central portion of the first electrode E1. A light emitting area LA, which is an area where light is emitted from the light emitting element LED, may be defined by the pixel opening PO. The pixel defining layer PDL may include an organic insulating material. In an embodiment, the pixel defining layer PDL may further include an inorganic material or an organic material including (or containing) a light blocking material having a black color.

The intermediate layer ML may be disposed on the first electrode E1 and the pixel defining layer PDL. In an embodiment, the intermediate layer ML may include a lower functional layer, an emission layer disposed on the lower functional layer, and an upper functional layer disposed on the emission layer. The lower functional layer may include a hole injection layer and/or a hole transport layer. The upper functional layer may include an electron transport layer and/or an electron injection layer.

The second electrode E2 may be disposed on the intermediate layer ML. The second electrode E2 may include a conductive material. In an embodiment, for example, the second electrode E2 may be a cathode of the light emitting element LED.

The encapsulation layer ENC may be disposed on the second electrode E2. The encapsulating layer ENC may seal the display layer DPL to protect the light emitting element LED. In an embodiment, the encapsulating layer ENC may include at least one inorganic encapsulating layer and at least one organic encapsulating layer.

Referring back to FIG. 4, the first protective layer PL1 may be disposed on the display panel DP. The first protective layer PL1 may be disposed on the upper surface DP-u of the display panel DP. The first protective layer PL1 may protect the display panel DP. In an embodiment, the first protective layer PL1 may also serve to prevent or reduce external light reflection. In an embodiment, for example, the first protective layer PL1 may be attached to the upper surface DP-u of the display panel DP through a first adhesive layer AD1.

The window WD may be disposed on the first protective layer PL1. The window WD may be disposed on an upper surface of the first protective layer PL1. The window WD may protect the display panel DP. In an embodiment, for example, the window WD may be attached to the upper surface of the first protective layer PL1 through a second adhesive layer AD2.

The window WD may include an optically transparent material. In an embodiment, the window WD may include glass or plastic. In an embodiment, for example, the window WD may include ultra-thin glass (UTG) having a thickness of about 0.1 millimeters or less, polyimide (PI), polyethylene terephthalate (PET), polycarbonate (PC), or the like.

The window protective layer PLW may be disposed on the window WD. The window protective layer PLW may be disposed on an upper surface of the window WD. The window protective layer PLW may protect the window WD. In an embodiment, the window protective layer PLW may also serve to resist fingerprints, prevent or reduce glare or external light reflection, or the like. In an embodiment, for example, the window protective layer PLW may be attached to the upper surface of the window WD through a third adhesive layer AD3.

The second protective layer PL2 may be disposed under the display panel DP. The second protective layer PL2 may be disposed under the lower surface DP-b of the display panel DP. The second protective layer PL2 may support the display panel DP and protect the lower surface DP-b of the display panel DP. In an embodiment, for example, the second protective layer PL2 may be attached to the lower surface DP-b of the display panel DP through a fourth adhesive layer AD4.

The barrier layer BR may be disposed under the second protective layer PL2. The barrier layer BR may be disposed under a lower surface of the second protective layer PL2. The barrier layer BR may prevent or reduce impurities, such as oxygen or moisture, from penetrating into the second protective layer PL2 and the display panel DP. In an embodiment, the barrier layer BR may have a color that absorbs light. In an embodiment, for example, the barrier layer BR may have a black color. In an embodiment, for example, the barrier layer BR may be attached to the lower surface of the second protective layer PL2 through a fifth adhesive layer AD5.

The support plate PT may be disposed under the barrier layer BR. The support plate PT may be disposed under a lower surface of the barrier layer BR. That is, the support plate PT may be disposed under the lower surface DP-b of the display panel DP. In an embodiment, for example, the support plate PT may be attached to the lower surface of the barrier layer BR through a sixth adhesive layer AD6.

The support plate PT may increase the strength and rigidity of the display device DD. The support plate PT may include a material having relatively high rigidity. In an embodiment, the support plate PT may include a non-metallic material, such as a carbon fiber reinforced plastic (CFRP), a glass fiber reinforced plastic (GFRP), or the like. In an embodiment, the support plate PT may also include a metal or an alloy, such as stainless steel (SUS), Al, Mg, Ti, or the like.

FIG. 6 is a bottom view illustrating a support plate according to an embodiment.

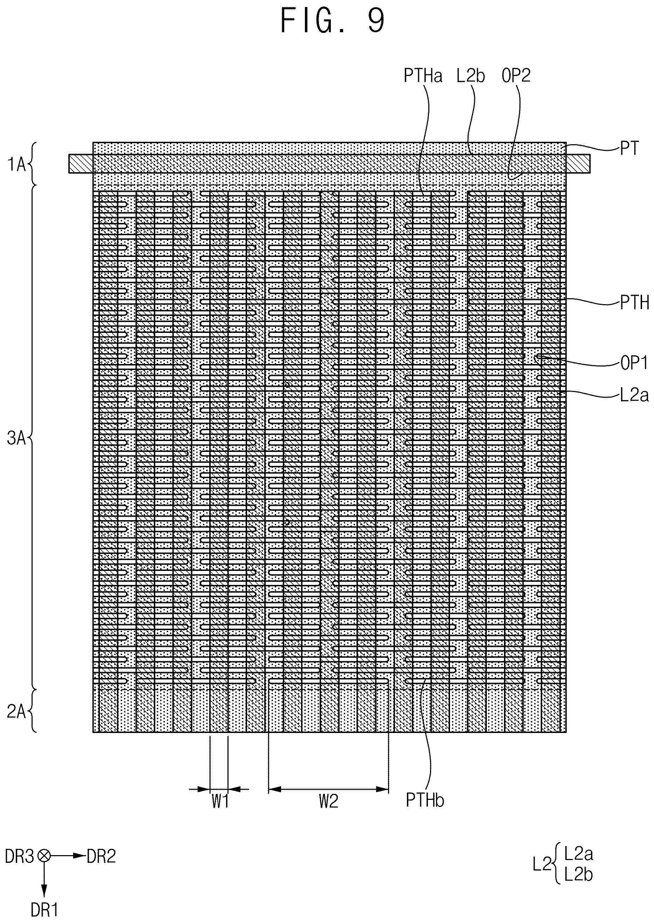

Referring to FIGS. 4 and 6, the holes PTH are defined in the support plate PT. The holes PTH may penetrate the support plate PT in the thickness direction (e.g., in the third direction DR3). Each of the holes PTH may have a shape extending in the second direction DR2 in a plan view (or when viewed in the third direction DR3). As described above, the second direction DR2 may be a direction parallel to the reference axis AX1, along which the electronic device 10 slides (see FIG. 2), or a direction parallel to the folding axis AX2, along which the electronic device 10 is folded (see FIG. 3). In an embodiment, the holes PTH may have the same width (e.g., W2 in FIG. 9) in the second direction DR2, but the invention is not limited thereto.

In an embodiment, the holes PTH may be formed by a laser process, a microblast process, or the like. The holes PTH may be defined in an area where the display device DD slides (or, is folded), thereby increasing the flexibility of the support plate PT. Accordingly, the support plate PT may easily slide (or, be easily folded).

In an embodiment, the support plate PT includes a first area 1A, a second area 2A, and a third area 3A. The third area 3A is an area where the holes PTH are defined, and the first area 1A and the second area 2A may be areas where the holes PTH are not defined.

In an embodiment, as illustrated in FIG. 6, the first area 1A and the second area 2A may be opposite side portions of the support plate PT in the first direction DR1. The second area 2A may be positioned in the first direction DR1 from the first area 1A. The third area 3A is an area between the first area 1A and the second area 2A.

In an embodiment, as illustrated in FIG. 6, a width of the third area 3A in the first direction DR1 may be greater than each of a width of the first area 1A in the first direction DR1 and a width of the second area 2A in the first direction DR1. That is, an area of the third area 3A where the holes PTH are defined may be greater than an area of each of the first and second areas 1A and 2A where the holes PTH are not defined. In other words, the holes PTH each extending in the second direction DR2 may be defined in most areas of the support plate PT.

In an embodiment, the entire display area DA of the display panel DP may overlap the third area 3A of the support plate PT in a plan view. In other words, the holes PTH may be defined in the support plate PT to correspond to the entire display area DA of the display panel DP.

In a plan view, the holes PTH may each extend in the second direction DR2, and may be repeatedly disposed in the first direction DR1 and the second direction DR2. In an embodiment, as illustrated in FIG. 6, the holes PTH may be disposed to be staggered in the first direction DR1.

In an embodiment, the sixth adhesive layer AD6 may be provided with substantially the same size as the barrier layer BR. The sixth adhesive layer AD6 may overlap most areas of the display area DA in a plan view. In an embodiment, the sixth adhesive layer AD6 may overlap all of the holes PTH of the support plate PT in a plan view. That is, the sixth adhesive layer AD6 may contact the entire upper surface of the third area 3A of the support plate PT defining the holes PTH. In other words, the sixth adhesive layer AD6 may also be disposed in an area where the display panel DP is bent, such as a sliding area, a foldable area, a bending area, or the like.

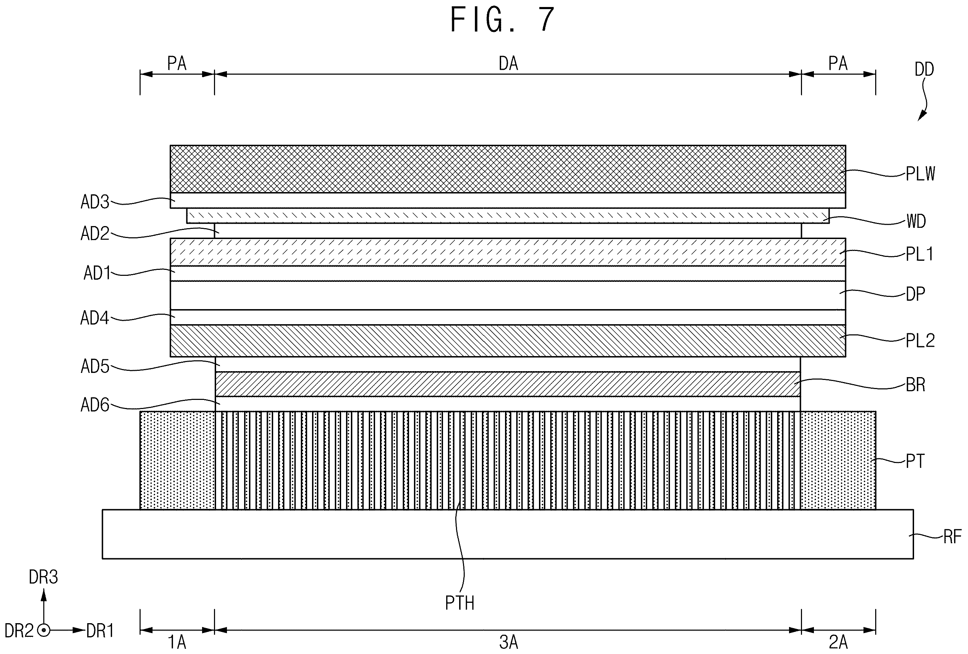

FIG. 7 is a cross-sectional view illustrating a display device according to an embodiment.

In an embodiment, referring to FIG. 7, an embodiment of the display device DD may further include a release film RF disposed under the support plate PT. The release film RF may be disposed under a lower surface of the support plate PT. The release film RF may be attached to the lower surface of the support plate PT.

The release film RF may protect the lower surface of the support plate PT during the manufacturing process of the electronic device 10. The release film RF may be separated and removed from the support plate PT as desired. In an embodiment, for example, the release film RF may be separated and removed from the support plate PT before the display device DD is assembled into the housing (e.g., the housing HS of FIG. 2).

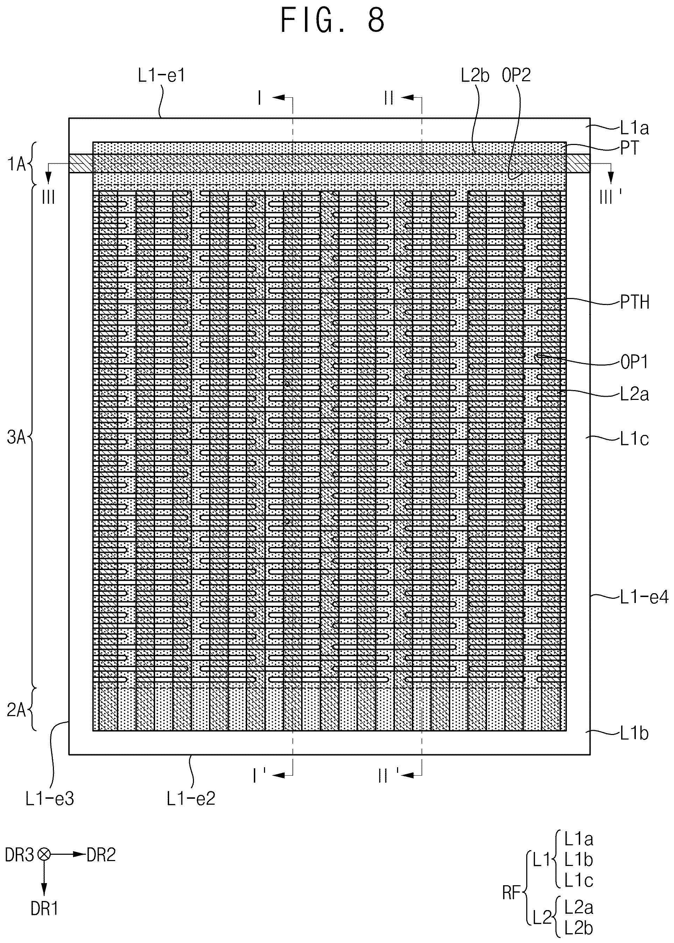

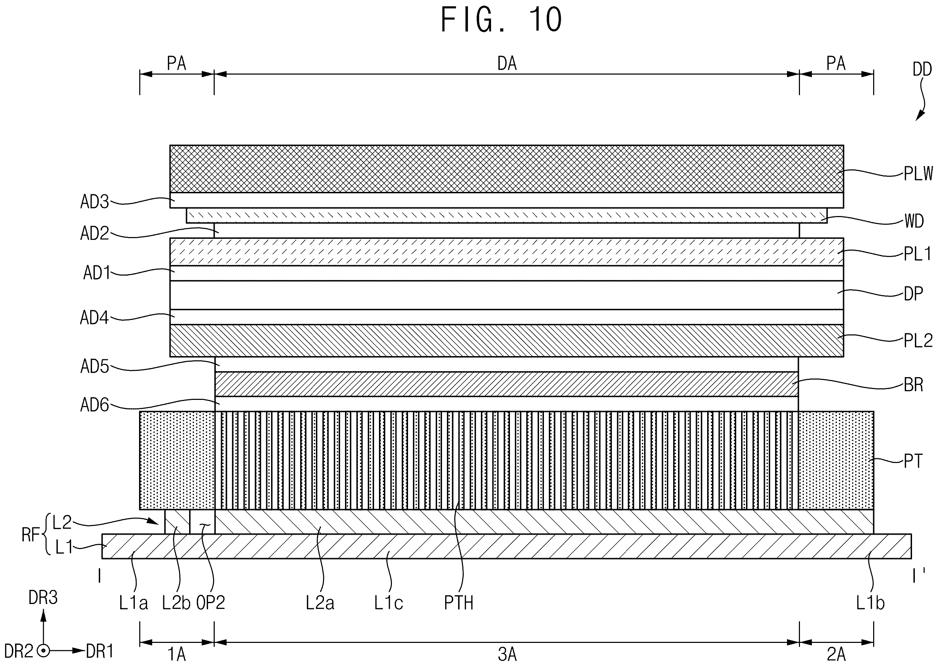

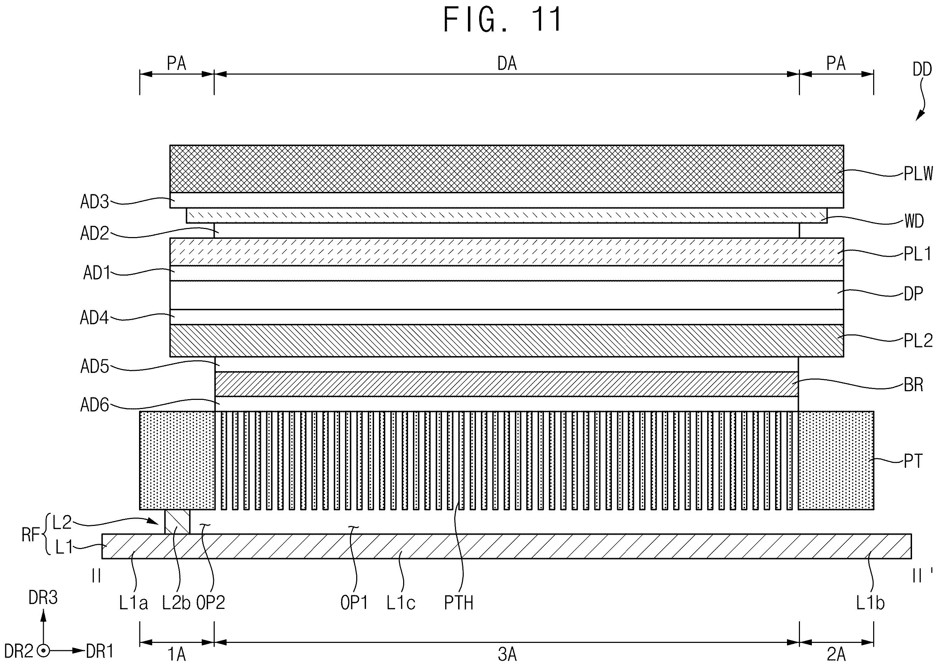

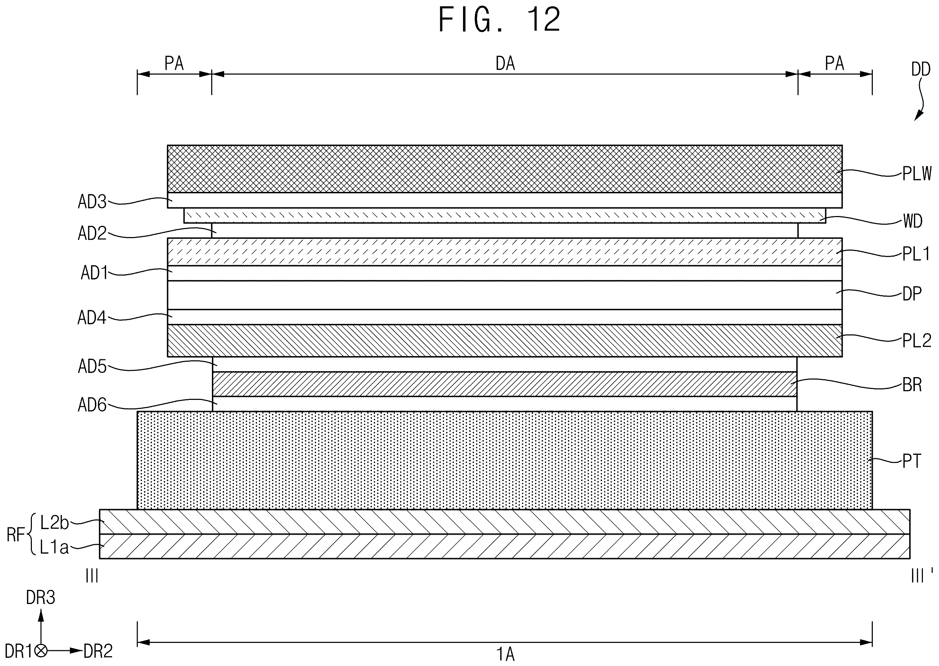

FIGS. 8 and 9 are bottom views illustrating a support plate and a release film according to an embodiment. FIG. 10 is a cross-sectional view taken along line I-I' of FIG. 8. FIG. 11 is a cross-sectional view taken along line II-II' of FIG. 8. FIG. 12 is a cross-sectional view taken along line III-III' of FIG. 8.

For convenience of illustration and description, the hatching of a first sub-layer L1 is omitted in FIG. 8.

In an embodiment, referring to FIGS. 7 to 12, the release film RF includes a first sub-layer L1 and a second sub-layer L2 disposed on the first sub-layer L1. The second sub-layer L2 may be disposed under the support plate PT, and the first sub-layer L1 may be disposed under the second sub-layer L2. The second sub-layer L2 may be disposed between the first sub-layer L1 and the support plate PT.

The second sub-layer L2 may be disposed under the lower surface of the support plate PT. In an embodiment, for example, an upper surface of the second sub-layer L2 may directly contact the lower surface of the support plate PT. The upper surface of the second sub-layer L2 may be adhered to the lower surface of the support plate PT. The upper surface of the second sub-layer L2 may be adhesive.

The first sub-layer L1 may be disposed under a lower surface of the second sub-layer L2. In an embodiment, for example, an upper surface of the first sub-layer L1 may directly contact the lower surface of the second sub-layer L2. The upper surface of the first sub-layer L1 may be adhered to the lower surface of the second sub-layer L2. In an embodiment, for example, at least one selected from the upper surface of the first sub-layer L1 and the lower surface of the second sub-layer L2 may be adhesive. In an embodiment, for example, a lower surface of the first sub-layer L1 may be non-adhesive.

In an embodiment, the release film RF may further include a third sub-layer (not shown) disposed under the first sub-layer L1.

FIG. 8 illustrates the support plate PT, the first sub-layer L1 of the release film RF, and the second sub-layer L2 of the release film RF. For convenience of illustration and description, FIG. 9 omits the first sub-layer L1 in FIG. 8 and illustrates the support plate PT and the second sub-layer L2 of the release film RF.

In an embodiment, the first sub-layer L1 may overlap the entire support plate PT in a plan view (or when viewed in the third direction DR3). In an embodiment, as illustrated in FIG. 8, in a plan view, a size (or a planar area) of the first sub-layer L1 may be greater than a size (or a planar area) of the support plate PT. That is, in a plan view, a size of the release film RF may be greater than the size of the support plate PT.

In an embodiment, as illustrated in FIG. 8, the first sub-layer L1 may have a rectangular planar shape. In an embodiment, for example, the first sub-layer L1 may include a first edge L1-e1 extending in the second direction DR2, a second edge L1-e2 extending in the second direction DR2 and positioned in the first direction DR1 from the first edge L1-e1, a third edge L1-e3 extending in the first direction DR1, and a fourth edge L1-e4 extending in the first direction DR1 and positioned in the second direction DR2 from the third edge L1-e3. In an embodiment, for example, the first and second edges L1-e1 and L1-e2 may be short sides of the first sub-layer L1, and the third and fourth edges L1-e3 and L1-e4 may be long sides of the first sub-layer L1. However, this is an example and the invention is not limited thereto, and the planar shape of the first sub-layer L1 may be variously changed.

In an embodiment, in a plan view, the edges L1-e1, L1-e2, L1-e3, and L1-e4 of the first sub-layer L1 may be disposed outside edges of the support plate PT.

In an embodiment, the first sub-layer L1 includes a first side portion L1a, a second side portion L1b, and a central portion L1c. The first side portion L1a and the second side portion L1b may be opposite sides of the first sub-layer L1 in the first direction DR1. The second side portion L1b may be positioned in the first direction DR1 from the first side portion L1a. The central portion L1c is positioned between the first side portion L1a and the second side portion L1b.

The first side portion L1a of the first sub-layer L1 may overlap the first area 1A of the support plate PT in a plan view. The first side portion L1a of the first sub-layer L1 may be positioned under the first area 1A of the support plate PT. The second side portion L1b of the first sub-layer L1 may overlap the second area 2A of the support plate PT in a plan view. The second side portion L1b of the first sub-layer L1 may be positioned under the second area 2A of the support plate PT. That is, the first side portion L1a and the second side portion L1b of the first sub-layer L1 may be portions that do not overlap the holes PTH of the support plate PT in a plan view.

The central portion L1c of the first sub-layer L1 may overlap the third area 3A of the support plate PT in a plan view. The central portion L1c of the first sub-layer L1 may be positioned under the third area 3A of the support plate PT. That is, the central portion L1c of the first sub-layer L1 may be a portion that overlaps the holes PTH of the support plate PT in a plan view.

In an embodiment, a width of the central portion L1c of the first sub-layer L1 in the first direction DR1 may be greater than each of a width of the first side portion L1a of the first sub-layer L1 in the first direction DR1 and a width of the second side portion L1b of the first sub-layer L1 in the first direction DR1.

In an embodiment, the second sub-layer L2 includes first extension patterns L2a and a second extension pattern L2b.

The first extension patterns L2a are disposed on the central portion L1c of the first sub-layer L1. The first extension patterns L2a may overlap the third area 3A of the support plate PT in a plan view. The first extension patterns L2a may be disposed between the central portion L1c of the first sub-layer L1 and the third area 3A of the support plate PT.

The first extension patterns L2a each extend in the first direction DR1, and are spaced apart from each other in the second direction DR2. In an embodiment, the first extension patterns L2a may each have a same width (e.g., W1 in FIG. 9) in the second direction DR2, and may be spaced apart at a constant interval in the second direction DR2, but the invention is not limited thereto.

First openings OP1 may be defined in the second sub-layer L2. Each of the first openings OP1 may be defined by two first extension patterns L2a that are adjacent to each other in the second direction DR2 among the first extension patterns L2a. That is, each of the first openings OP1 may be defined as a space between two first extension patterns L2a that are adjacent to each other in the second direction DR2, between the first sub-layer L1 and the support plate PT.

Each of the first openings OP1 may have a shape extending in the first direction DR1. In a plan view, the first openings OP1 may be spaced apart from each other in the second direction DR2. In an embodiment, the first openings OP1 may each have a same width in the second direction DR2, but the invention is not limited thereto.

In an embodiment, as illustrated in FIG. 9, the width W1 of each of the first extension patterns L2a in the second direction DR2 may be less than the width W2 of each of the holes PTH of the support plate PT in the second direction DR2. Accordingly, at least a portion of each of the holes PTH may not be covered by the first extension patterns L2a. In other words, none of the holes PTH of the support plate PT may be completely covered by the second sub-layer L2 of the release film RF.

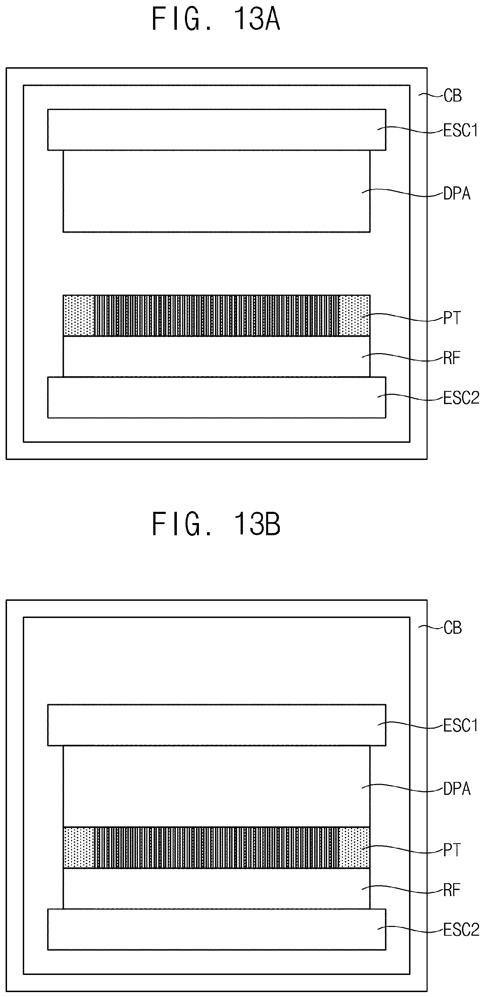

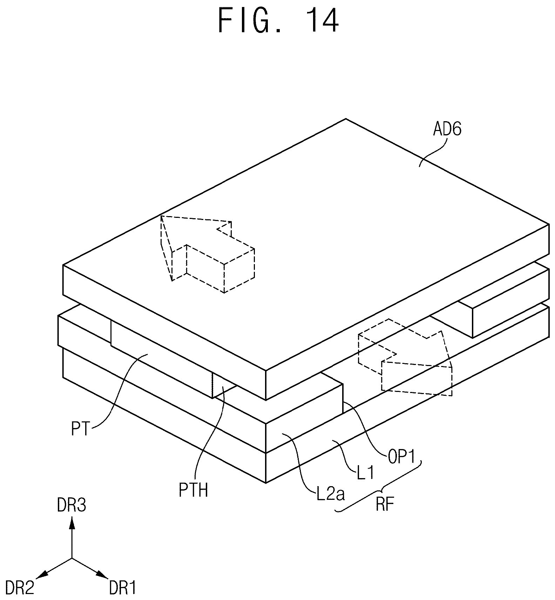

As illustrated in FIGS. 8 and 11, each of the first openings OP1 of the second sub-layer L2 may be connected to some of the holes PTH of the support plate PT that overlap therewith in a plan view. The first openings OP1 may function as passages through which air can be discharged during a lamination process of the display panel DP and the support plate PT, thereby effectively preventing or substantially reducing the display panel DP from bending. This will be described in detail later with reference to FIGS. 13 and 14.

The second extension pattern L2b is disposed on the first side portion L1a of the first sub-layer L1. The second extension pattern L2b may overlap the first area 1A of the support plate PT in a plan view. The second extension pattern L2b may be disposed between the first side portion L1a of the first sub-layer L1 and the first area 1A of the support plate PT.

The second extension pattern L2b extends in the second direction DR2. In an embodiment, as illustrated in FIG. 8, in a plan view, the second extension pattern L2b may extend from the third edge L1-e3 of the first sub-layer L1 to the fourth edge L1-e4 of the first sub-layer L1. In an embodiment, for example, a length of the second extension pattern L2b in the second direction DR2 may be equal to a width of the first sub-layer L1 in the second direction DR2.

The length of the second extension pattern L2b in the second direction DR2 may be greater than a width of the support plate PT in the second direction DR2. That is, in a plan view, an end portion of the second extension pattern L2b in the second direction DR2 may protrude outward from the support plate PT (see FIGS. 9 and 12). The end portion of the second extension pattern L2b that protrudes outward from the support plate PT may function as a grip portion for easily separating the release film RF from the support plate PT. In an embodiment, as illustrated in FIG. 9, in a plan view, both opposing end portions of the second extension pattern L2b in the second direction DR2 may protrude outward from the support plate PT. In another embodiment, only one of the both opposing end portions of the second extension pattern L2b may protrude outward from the support plate PT.

In an embodiment, the first extension patterns L2a and the second extension pattern L2b may directly contact the support plate PT. Upper surfaces of the first extension patterns L2a and an upper surface of the second extension pattern L2b may directly contact the lower surface of the support plate PT.

In an embodiment, the first extension patterns L2a may be spaced apart from the second extension pattern L2b in the first direction DR1.

A second opening OP2 that is connected to the first openings OP1 may be defined in the second sub-layer L2. The second opening OP2 may be defined by the second extension pattern L2b and the first extension patterns L2a. The second opening OP2 may be defined as a space between the second extension pattern L2b that extends in the second direction DR2 and the first extension patterns L2a that are spaced apart from the second extension pattern L2b in the first direction DR1, between the first sub-layer L1 and the support plate PT. The second opening OP2 may have a shape extending in the second direction DR2.

As the first extension patterns L2a are spaced apart from the second extension pattern L2b, the second opening OP2 extending in the second direction DR2 may be connected to the first openings OP1 each extending in the first direction DR1. Accordingly, air from the holes PTH of the support plate PT may move in the first direction DR1 through the first openings OP1 and be discharged to the outside, or may move in a direction opposite to the first direction DR1 through the first openings OP1, move in the second direction DR2 or in a direction opposite to the second direction DR2 through the second opening OP2, and be discharged to the outside.

In an embodiment, as illustrated in FIG. 9, each of the first extension patterns L2a may have a shape extending from a hole PTHa closest to the first area 1A among the holes PTH of the support plate PT to a hole PTHb closest to the second area 2A among the holes PTH of the support plate PT.

In an embodiment, the first extension patterns L2a may further overlap the second area 2A of the support plate PT in a plan view. That is, the first extension patterns L2a may also be disposed on the second side portion L1b of the first sub-layer L1. In other words, the first extension patterns L2a may be disposed between the central portion L1c of the first sub-layer L1 and the third area 3A of the support plate PT and between the second side portion L1b of the first sub-layer L1 and the second area 2A of the support plate PT.

In an embodiment, in a plan view, each of the first extension patterns L2a may extend from the hole PTHa closest to the first area 1A to an edge of the support plate PT in the first direction DR1. In an embodiment, in a plan view, each of the first extension patterns L2a may not extend to the second edge L1-e2 of the first sub-layer L1. That is, as illustrated in FIG. 8, the second edge L1-e2 of the first sub-layer L1 may be positioned in the first direction DR1 from an edge of each of the first extension patterns L2a in the first direction DR1.

In an embodiment, the first extension patterns L2a may not overlap the first area 1A of the support plate PT in a plan view. That is, the first extension patterns L2a may not be disposed on the first side portion L1a of the first sub-layer L1. In other words, the first extension patterns L2a may not be disposed between the first side portion L1a of the first sub-layer L1 and the first area 1A of the support plate PT. Accordingly, when the release film RF is separated and removed from the support plate PT, it is possible to effectively prevent or substantially reduce a problem in which only the first sub-layer L1 is separated from the support plate PT and at least some of the first extension patterns L2a of the second sub-layer L2 are not separated from the support plate PT (i.e., remain attached to the support plate PT).

FIGS. 13A and 13B are views schematically illustrating a method of manufacturing a display device according to an embodiment. FIG. 14 is a perspective view illustrating a portion of a release film and a portion of a support plate according to an embodiment.

Referring to FIGS. 13A and 13B, in an embodiment of a method of manufacturing a display device, during the manufacturing process of the display device DD, the support plate PT to which the release film RF is attached may be laminated to a display panel assembly DPA in a chamber CB. In an embodiment, for example, the display panel assembly DPA may be a stacked structure including from the sixth adhesive layer AD6 to the window protective layer PLW of FIG. 7. The display panel assembly DPA may be fixed by a first electrostatic chuck ESC1, and the support plate PT to which the release film RF is attached may be fixed by a second electrostatic chuck ESC2. The upper surface of the support plate PT to which the release film RF is not attached may be attached to a lower surface of the display panel assembly DPA (e.g., a lower surface of the sixth adhesive layer AD6 of FIG. 7).

In an embodiment, in order to remove bubble, the support plate PT may be laminated to the display panel assembly DPA in a vacuum atmosphere. In this process, as illustrated in FIG. 14, the release film RF according to embodiments may provide the passages through which air can move through the first openings OP1 of the second sub-layer L2. When forming a vacuum atmosphere inside the chamber CB, air inside the holes PTH of the support plate PT may be discharged to the outside through the first openings OP1 of the second sub-layer L2 of the release film RF. Accordingly, a vacuum atmosphere may also be formed inside the holes PTH of the support plate PT.

If the first openings OP1 are not defined in the release film RF, when forming a vacuum atmosphere inside the chamber CB, air inside the holes PTH of the support plate PT may not be discharged to the outside. For example, the upper surface of the support plate PT may be completely covered by the sixth adhesive layer AD6, and the lower surface of the support plate PT may be completely covered by the release film RF. Accordingly, when a vacuum atmosphere is formed outside the support plate PT, air inside the holes PTH of the support plate PT may expand, causing the support plate PT to bend. In addition, since the lamination between the support plate PT and the display panel assembly DPA is performed while the support plate PT is in a bent state, the display panel DP included in the display panel assembly DPA may also become bent. If the sixth adhesive layer AD6 is disposed only in areas that do not overlap the holes PTH of the support plate PT in order to provide passages through which air can move during the lamination process of the support plate PT and the display panel assembly DPA, the support plate PT may be easily separated from an upper layer (e.g., the barrier layer BR). In addition, if the holes PTH are defined in most areas of the support plate PT as described above, it is difficult to dispose the sixth adhesive layer AD6 only in areas that do not overlap the holes PTH of the support plate PT.

According to embodiments, the sixth adhesive layer AD6 may be disposed to overlap all of the holes PTH of the support plate PT in a plan view, and the release film RF may provide the passages through which air can move through the first openings OP1 of the second sub-layer L2. Accordingly, the support plate PT may be strongly attached to the upper layer by the sixth adhesive layer AD6, and a vacuum atmosphere may also be formed inside the holes PTH of the support plate PT when forming a vacuum atmosphere inside the chamber CB. Accordingly, during the lamination process of the support plate PT and the display panel assembly DPA, bending of the support plate PT and the display panel DP may be effectively prevented or substantially reduced. Therefore, the yield of the display device DD and the electronic device 10 may be improved.

After manufacturing the display device DD of FIG. 7 by laminating the support plate PT to which the release film RF is attached to the display panel assembly DPA, the release film RF may be separated and removed from the support plate PT as desired. In an embodiment, for example, the release film RF may be separated and removed from the support plate PT before the display device DD is assembled into the housing (e.g., the housing HS of FIG. 2).

In this process, unlike FIGS. 8 to 12, if the second extension pattern L2b is omitted and the first extension patterns L2a are further extended in the direction opposite to the first direction DR1 to be also disposed on the first side portion L1a of the first sub-layer L1, the adhesive force between the upper surface of each first extension pattern L2a and the lower surface of the support plate PT may be greater in the first area 1A than in the third area 3A. This is because, per unit area, the first area 1A of the support plate PT where the holes PTH are not defined has a greater contact area with the first extension pattern L2a than the third area 3A of the support plate PT where the holes PTH are defined. In this case, when an end portion (e.g., upper left or upper right corner in FIG. 8) of the first sub-layer L1 is gripped and the release film RF is separated from the support plate PT, a problem in which only the first sub-layer L1 is separated from the support plate PT and at least some of the first extension patterns L2a of the second sub-layer L2 are not separated from the support plate PT may occur. If the adhesive strength of the upper surface of the second sub-layer L2 is reduced to solve this problem, another problem in which the release film RF is not properly attached to the support plate PT and is lifted may occur. In this case, the yield of the display device DD and the electronic device 10 may decrease.

According to embodiments, as illustrated in FIGS. 8 to 12, the first extension patterns L2a may be attached to the third area 3A of the support plate PT where the holes PTH are defined, and may not be attached to the first area 1A of the support plate PT where the holes PTH are not defined. That is, the first extension patterns L2a may be attached to the third area 3A of the support plate PT, which has a relatively small contact area per unit area, and may not be attached to the first area 1A of the support plate PT, which has a relatively large contact area per unit area. In addition, the second extension pattern L2b extending in the second direction DR2 may be attached to the first area 1A of the support plate PT, which has a relatively large contact area per unit area. The end portion of the second extension pattern L2b in the second direction DR2 may protrude outward from the support plate PT. Therefore, the release film RF may be separated from the support plate PT by gripping end portion of the second extension pattern L2b, not only the second extension pattern L2b but also the first extension patterns L2a attached to the third area 3A of the support plate PT having a relatively small contact area per unit area (i.e., attached with a relatively small adhesive force), may be easily separated from the support plate PT. Accordingly, it is possible to effectively prevent or substantially reduce a problem in which only the first sub-layer L1 is separated from the support plate PT and at least some of the first extension patterns L2a of the second sub-layer L2 are not separated from the support plate PT, without reducing the adhesive strength of the upper surface of the second sub-layer L2. Therefore, the yield of the display device DD and the electronic device 10 may be further improved.

In an embodiment, the release film RF of FIGS. 7 to 12 may be manufactured by laminating the first extension patterns L2a and the second extension pattern L2b, which are cut from a base release film using a cutting apparatus, to the first sub-layer L1. In another embodiment, the release film RF may be manufactured by laminating the second sub-layer L2 to the entire surface of the first sub-layer L1, and then cutting only portions of the second sub-layer L2 using a cutting apparatus.

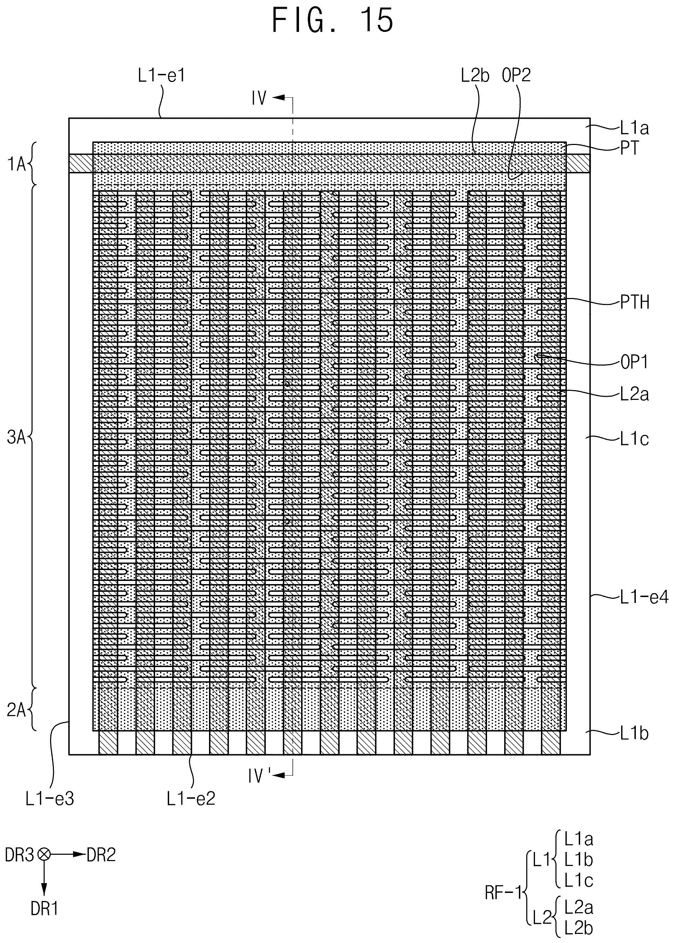

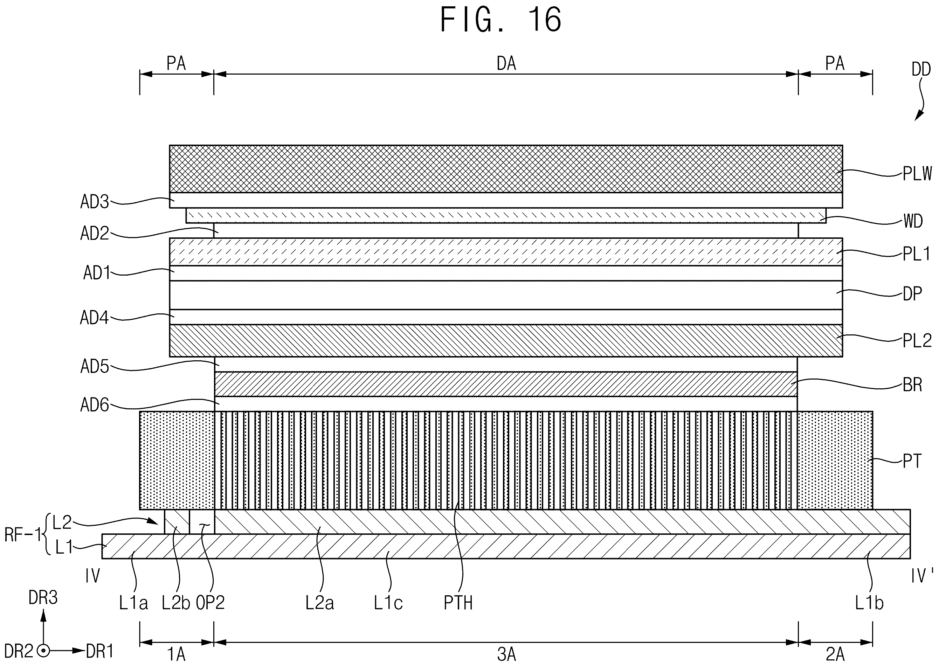

FIG. 15 is a bottom view illustrating a support plate and a release film according to an embodiment. FIG. 16 is a cross-sectional view taken along line IV-IV' of FIG. 15.

For convenience of illustration and description, the hatching of the first sub-layer L1 is omitted in FIG. 15.

A release film RF-1 of FIGS. 15 and 16 may be substantially the same as or similar to the release film RF described above with reference to FIGS. 8 to 12, except for the length of each of the first extension patterns L2a of the second sub-layer L2. Therefore, any repetitive detailed description of the same or like elements as those described above will be omitted or simplified.

Referring to FIGS. 15 and 16, in an embodiment, in a plan view, each of the first extension patterns L2a may extend to the second edge L1-e2 of the first sub-layer L1. That is, in a plan view, an end portion of each of the first extension patterns L2a in the first direction DR1 may protrude outward from the support plate PT.

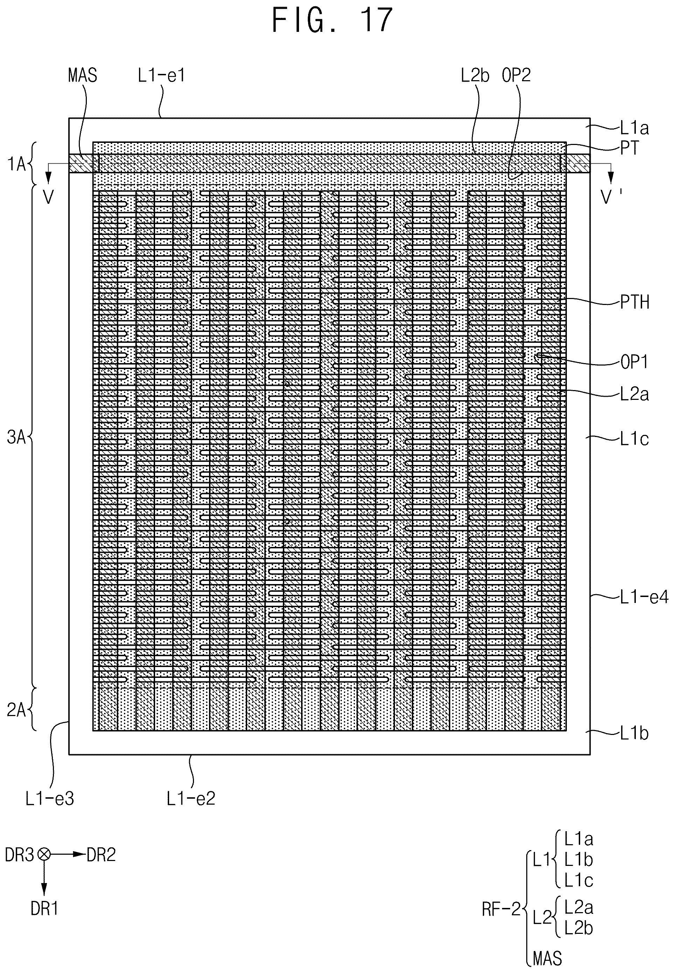

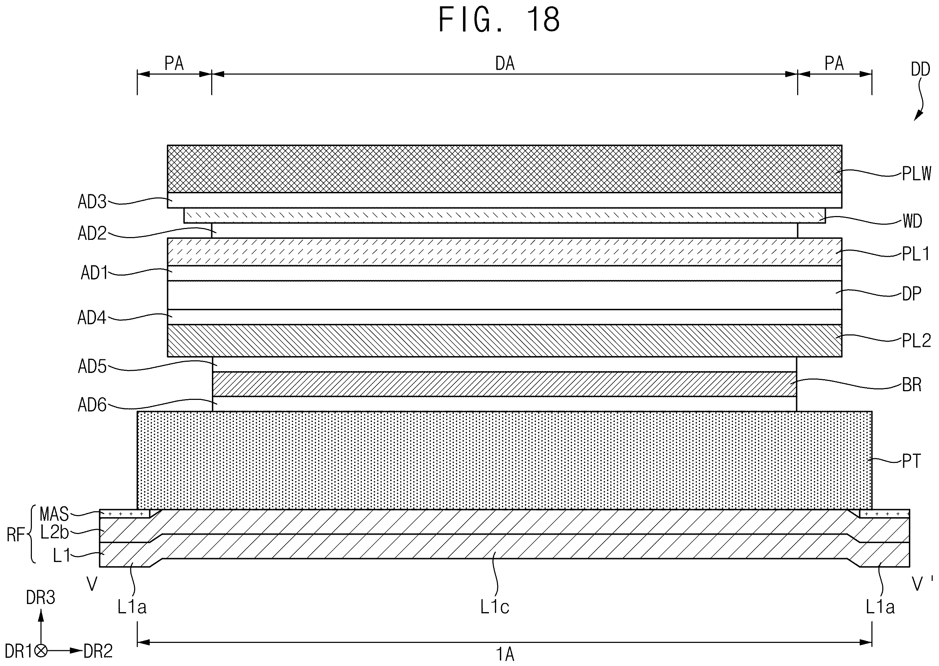

FIG. 17 is a bottom view illustrating a support plate and a release film according to an embodiment. FIG. 18 is a cross-sectional view taken along line V-V' of FIG. 17.

For convenience of illustration and description, the hatching of the first sub-layer L1 is omitted in FIG. 17.

A release film RF-2 of FIGS. 17 and 18 may be substantially the same as or similar to the release film RF described above with reference to FIGS. 8 to 12, except that the release film RF-2 further includes a masking pattern MAS. Therefore, any repetitive detailed description of the same or like elements as those described above will be omitted or simplified.

Referring to FIGS. 17 and 18, in an embodiment, the release film RF-2 may include the masking pattern MAS disposed on the second extension pattern L2b of the second sub-layer L2. The masking pattern MAS may be disposed or defined on the upper surface of the second extension pattern L2b.

In an embodiment, the masking pattern MAS may be disposed on the end portion of the second extension pattern L2b in the second direction DR2 that protrudes outward from the support plate PT in a plan view. That is, the masking pattern MAS may be attached on the end portion of the second extension pattern L2b that functions as a grip portion for easily separating the release film RF from the support plate PT.

In an embodiment, as illustrated in FIG. 17, when the both opposing end portions of the second extension pattern L2b in the second direction DR2 protrude outward from the support plate PT, two masking patterns MAS may be respectively disposed on the both opposing end portions of the second extension pattern L2b. However, the invention is not limited thereto, and one masking pattern MAS may be disposed on one of the both end portions of the second extension pattern L2b.

In an embodiment, as illustrated in FIG. 17, the masking pattern MAS may partially overlap the first area 1A of the support plate PT in a plan view. In an embodiment, for example, the masking pattern MAS may include a first portion that does not overlap the support plate PT in a plan view, and a second portion that overlaps the support plate PT in a plan view. The first portion of the masking pattern MAS may be a portion that protrudes outward from the support plate PT in a plan view.

The masking pattern MAS may include a first surface (e.g., a lower surface) facing the end portion of the second extension pattern L2b and a second surface (e.g., an upper surface) opposite to the first surface.

A lower surface of the masking pattern MAS may directly contact an upper surface of the end portion of the second extension pattern L2b. The lower surface of the masking pattern MAS may be adhered to the upper surface of the end portion of the second extension pattern L2b.

An upper surface of the second portion of the masking pattern MAS may directly contact the lower surface of the support plate PT. The upper surface of the masking pattern MAS may be non-adhesive. That is, even when the upper surface of the second portion of the masking pattern MAS directly contacts the lower surface of the support plate PT, the upper surface of the second portion of the masking pattern MAS may not be adhered to the lower surface of the support plate PT. Therefore, when the release film RF is separated from the support plate PT, the second extension pattern L2b may be separated more easily from the support plate PT.

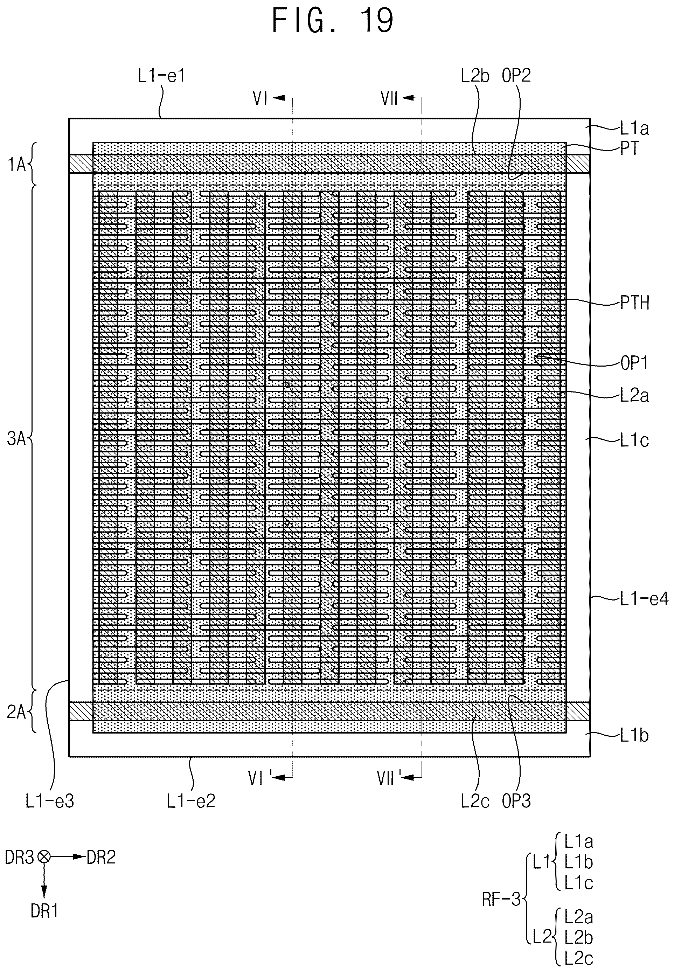

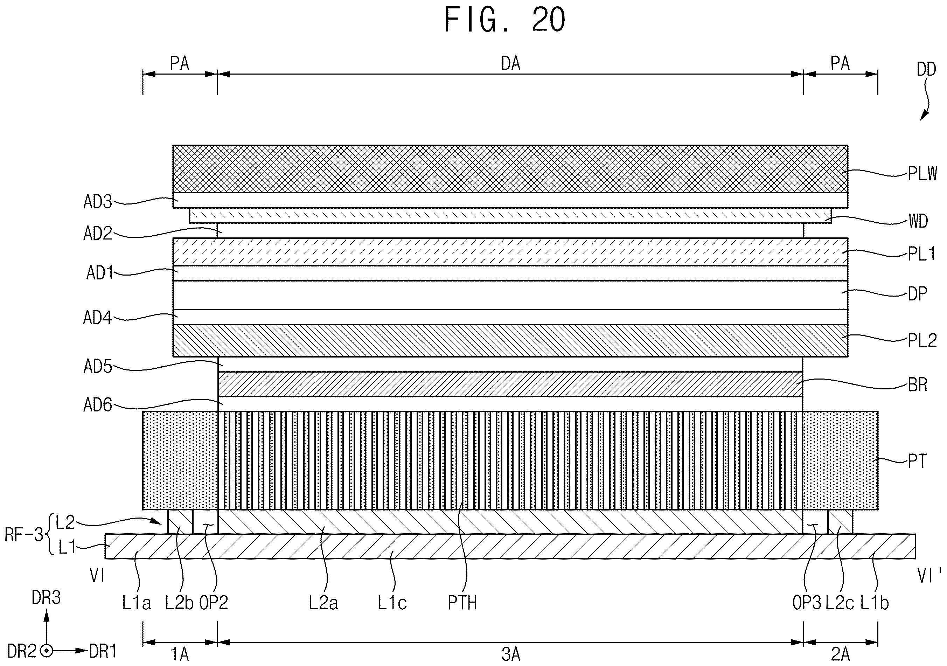

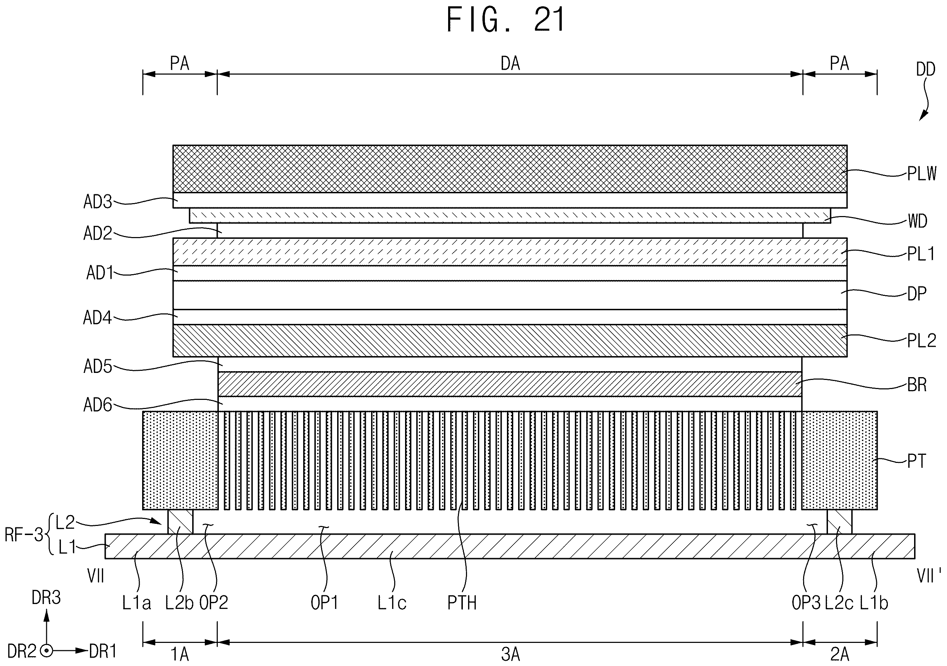

FIG. 19 is a bottom view illustrating a support plate and a release film according to an embodiment. FIG. 20 is a cross-sectional view taken along line VI-VI' of FIG. 19. FIG. 21 is a cross-sectional view taken along line VII-VII' of FIG. 19.

For convenience of illustration and description, the hatching of the first sub-layer L1 is omitted in FIG. 19.

A release film RF-3 of FIGS. 19 to 21 may be substantially the same as or similar to the release film RF described above with reference to FIGS. 8 to 12, except that the second sub-layer L2 further includes a third extension pattern L2c. Therefore, any repetitive detailed description of the same or like elements as those described above will be omitted or simplified.

Referring to FIGS. 19 to 21, in an embodiment, the second sub-layer L2 may further include the third extension pattern L2c disposed on the second side portion L1b of the first sub-layer L1. The third extension pattern L2c may overlap the second area 2A of the support plate PT in a plan view. The third extension pattern L2c may be disposed between the second side portion L1b of the first sub-layer L1 and the second area 2A of the support plate PT.

In an embodiment, in a plan view, each of the first extension patterns L2a may overlap the third area 3A of the support plate PT, and may not overlap the first area 1A and the second area 2A of the support plate PT. That is, the first extension patterns L2a may not be disposed on the first side portion L1a and the second side portion L1b of the first sub-layer L1. In other words, the first extension patterns L2a may not be disposed between the first side portion L1a of the first sub-layer L1 and the first area 1A of the support plate PT, and between the second side portion L1b of the first sub-layer L1 and the second area 2A of the support plate PT.

The third extension pattern L2c may be spaced apart from the second extension pattern L2b in the first direction DR1 with the first extension patterns L2a interposed therebetween.

The third extension pattern L2c may extend in the second direction DR2. In an embodiment, as illustrated in FIG. 19, the third extension pattern L2c may extend from the third edge L1-e3 of the first sub-layer L1 to the fourth edge L1-e4 in a plan view. In an embodiment, for example, a length of the third extension pattern L2c in the second direction DR2 may be equal to the width of the first sub-layer L1 in the second direction DR2. In an embodiment, for example, the length of the third extension pattern L2c in the second direction DR2 may be equal to the length of the second extension pattern L2b in the second direction DR2.

The length of the third extension pattern L2c in the second direction DR2 may be greater than the width of the support plate PT in the second direction DR2. That is, in a plan view, an end portion of the third extension pattern L2c in the second direction DR2 may protrude outward from the support plate PT (see FIG. 19). In an embodiment, as illustrated in FIG. 19, in a plan view, both end portions of the third extension pattern L2c in the second direction DR2 may protrude outward from the support plate PT. In an embodiment, only one of the both end portions of the third extension pattern L2c may protrude outward from the support plate PT.

In an embodiment, the third extension pattern L2c may be spaced apart from the first extension patterns L2a in the first direction DR1.

A third opening OP3 that is connected to the first openings OP1 may be defined in the second sub-layer L2. The third opening OP3 may be defined by the third extension pattern L2c and the first extension patterns L2a. The third opening OP3 may be defined as a space between the third extension pattern L2c that extends in the second direction DR2 and the first extension patterns L2a that are spaced apart from the third extension pattern L2c in the direction opposite to the first direction DR1, between the first sub-layer L1 and the support plate PT. The third opening OP3 may have a shape extending in the second direction DR2.

As the first extension patterns L2a are spaced apart from the third extension pattern L2c, the third opening OP3 extending in the second direction DR2 may be connected to the first openings OP1 each extending in the first direction DR1. Accordingly, air from the holes PTH of the support plate PT may move in the first direction DR1 through the first openings OP1, move in the second direction DR2 or in the direction opposite to the second direction DR2 through the third opening OP3, and be discharged to the outside, or may move in the direction opposite to the first direction DR1 through the first openings OP1, move in the second direction DR2 or in the direction opposite to the second direction DR2 through the second opening OP2, and be discharged to the outside.

According to embodiments of FIGS. 19 to 21, the end portion of the second extension pattern L2b and the end portion of the third extension pattern L2c may function as grip portions for easily separating the release film RF-3 from the support plate PT. Accordingly, the release film RF-3 may be more easily separated from the support plate PT.

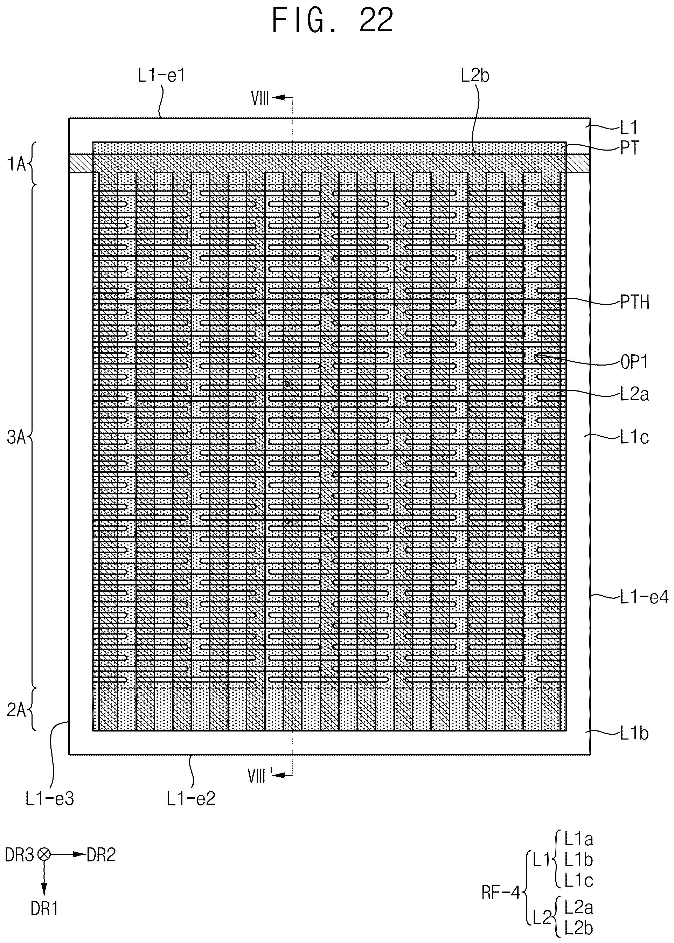

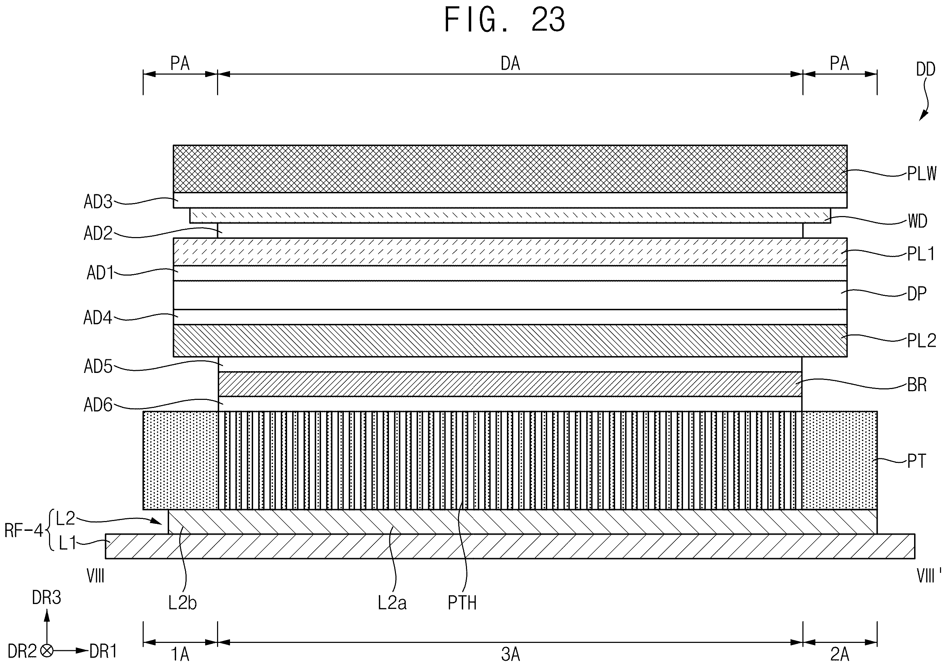

FIG. 22 is a bottom view illustrating a support plate and a release film according to an embodiment. FIG. 23 is a cross-sectional view taken along line VIII-VIII' of FIG 22.

For convenience of illustration and description, the hatching of the first sub-layer L1 is omitted in FIG. 22.

A release film RF-4 of FIGS. 22 and 23 may be substantially the same as or similar to the release film RF described above with reference to FIGS. 8 to 12, except that the first extension patterns L2a and the second extension pattern L2b of the second sub-layer L2 are integrally connected to each other or integrally formed with each other as a single unitary indivisible part. Therefore, any repetitive detailed description of the same or like elements as those described above will be omitted or simplified.

Referring to FIGS. 22 and 23, in an embodiment, the first extension patterns L2a may be integrally connected to the second extension pattern L2b. That is, the second sub-layer L2 may have a shape in which the first extension patterns L2a branch out and extend in the first direction DR1 from the second extension pattern L2b extending in the second direction DR2. Accordingly, the second opening OP2 of FIG. 8 may not be defined in the second sub-layer L2.

According to embodiment of FIGS. 22 and 23, since the second opening OP2 is not defined, the passage through which air can move during the lamination process of the support plate PT and the display panel assembly may be reduced, but the problem in which the first extension patterns L2a are not separated from the support plate PT during separation of the release film RF may be further effectively prevented or substantially reduced.

The display device according to embodiments may be applied to various electronic devices.

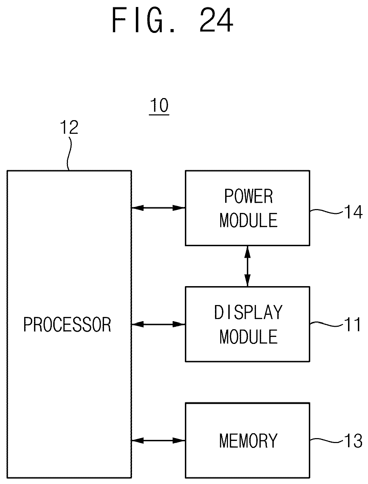

FIG. 24 is a block diagram illustrating an electronic device according to an embodiment.

Referring to FIG. 24, an electronic device 10 according to an embodiment may include a display module 11, a processor 12, a memory 13, and a power module 14.

In an embodiment, the electronic device 10 may include the display device (e.g., the display device DD of FIG. 4) according to embodiments described above. In an embodiment, the display module 11 may be included in the display device. The electronic device 10 may further include modules or devices with additional functions other than the display device.

The processor 12 may include at least one selected from a central processing unit (CPU), an application processor (AP), a graphic processing unit (GPU), a communication processor (CP), an image signal processor (ISP), and a controller.

In an embodiment, the processor 12 may be configured to provide an image data signal and/or an input control signal to the display device.

The memory 13 may store data information used for the operation of the processor 12 or the display module 11. When the processor 12 executes the application stored in the memory 13, the image data signal and/or the input control signal may be transmitted to the display module 11, and the display module 11 may process the received signal and output image information through a display screen.

The power module 14 may include a power supply module, such as a power adapter or a battery device, and a power conversion module which converts the power supplied by the power supply module to generate power used for the operation of the electronic device 10.

At least one of each component of the electronic device 10 described above may be included in the display device according to embodiments. In addition, some of the individual modules functionally included in one module may be included in the display device, and other portions may be provided separately from the display device. In an embodiment, for example, the display device may include the display module 11, and the processor 12, the memory 13, and the power module 14 may be provided in the form of other devices within the electronic device 10 other than the display device.

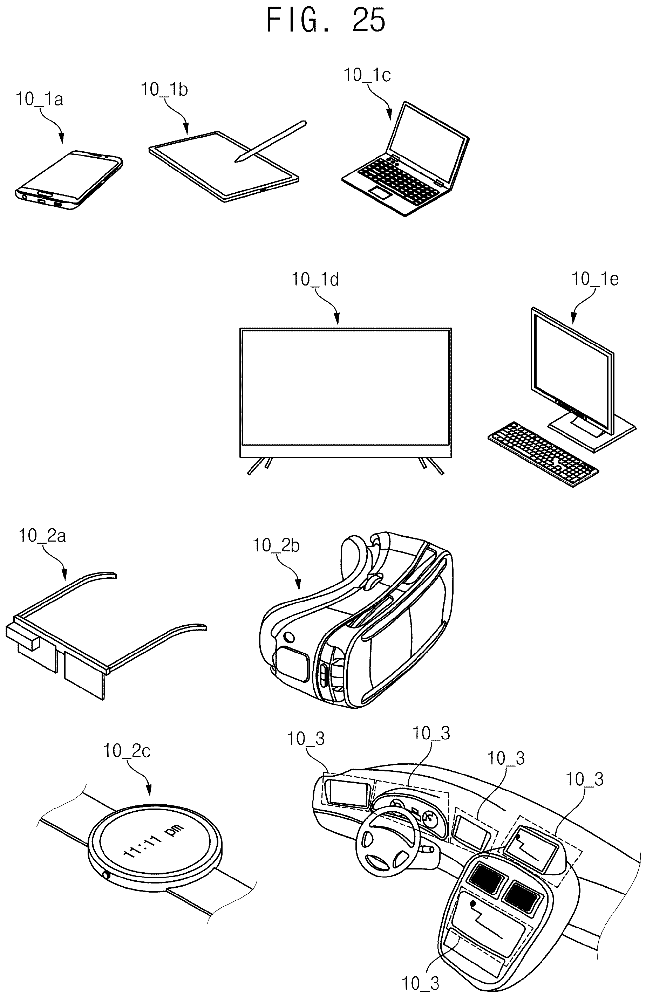

FIG. 25 is a schematic diagram illustrating electronic devices according to various embodiments.

Referring to FIGS. 24 and 25, various electronic devices 10 to which the display device according to embodiments are applied may include not only image display electronic devices such as a smartphone 10_1a, a tablet personal computer (PC) 10_1b, a laptop computer 10_1c, a television (TV) 10_1d, and a desktop monitor 10_1e, but also wearable electronic devices including display modules, such as smart glasses 10_2a, a head-mounted display 10_2b, and a smart watch 10_2c, automotive electronic devices 10_3 including display modules, such as a dashboard of a car, a center fascia, a center information display (CID) disposed on a dashboard, and a room mirror display, or the like.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A release film (RF) comprising:
a first sub-layer (L1); and
a second sub-layer (L2) disposed on the first sub-layer (L1),
wherein the first sub-layer (L1) includes:
a first side portion (L1a);
a second side portion (L1b) positioned in a first direction (DR1) from the first side portion (L1a); and
a central portion (L1c) between the first side portion (L1a) and the second side portion (L2a), and
wherein the second sub-layer (L2) includes:
first extension patterns (L2a) disposed on the central portion (L1c) of the first sub-layer (L1), each extending in the first direction (DR1), and spaced apart from each other in a second direction (DR2) crossing the first direction (DR1); and
a second extension pattern (L2b) disposed on the first side portion (L1a) of the first sub-layer (L1) and extending in the second direction (DR2).

2. The release film (RF) of claim 1, wherein the first extension patterns (L2a) are disposed on the second side portion (L1b) of the first sub-layer (L1).

3. The release film (RF) of claim 1 or claim 2, wherein first openings (OP1) are defined in the second sub-layer (L2), and
wherein each of the first openings (OP1) is defined by two adjacent first extension patterns (L2a) among the first extension patterns (L2a).

4. The release film (RF) of claim 3, wherein each of the first openings (OP1) extends in the first direction (DR1) and the first openings (OP1) are arranged in the second direction (DR2).

5. The release film (RF) of claim 3 or claim 4, wherein the first extension patterns (L2a) are spaced apart from the second extension pattern (L2b) in the first direction (DR1).

6. The release film (RF) of claim 5, wherein a second opening (OP2) connected to the first openings (OP1) is defined in the second sub-layer (L2), and
wherein the second opening (OP2) is defined by the first extension patterns (L2a) and the second extension pattern (L2b), optionally wherein the second opening (OP2) extends in the second direction (DR2).

7. The release film (RF-3) of claim 5 or claim 6, wherein the second sub-layer (L2) further includes a third extension pattern (L2c) disposed on the second side portion (L1b) of the first sub-layer (L1), spaced apart from the first extension patterns (L2a) in the first direction (DR1), and extending in the second direction (DR2), optionally wherein a third opening (OP3) connected to the first openings (OP1) is defined in the second sub-layer (L2), and
wherein the third opening (OP3) is defined by the first extension patterns (L2a) and the third extension pattern (L2c).

8. The release film (RF-4) of claim 3 or claim 4, wherein the first extension patterns (L2a) are integrally connected to the second extension pattern (L2b).

9. The release film (RF-2) of any one of claims 1 to 6, further comprising:
a masking pattern (MAS) disposed on an end portion of the second extension pattern (L2b),
wherein the masking pattern (MAS) includes a first surface which contacts the end portion of the second extension pattern (L2b) and a second surface opposite to the first surface,
wherein the second surface of the masking pattern (MAS) is non-adhesive.

10. The release film (RF) of any one of claims 1 to 9, wherein a width of the central portion (L1c) of the first sub-layer (L1) in the first direction (DR1) is greater than each of a width of the first side portion (L1a) of the first sub-layer (L1) in the first direction (DR1) and a width of the second side portion (L1b) of the first sub-layer (L1) in the first direction (DR1).

11. A display device (DD) comprising:
a display panel (DP);
a support plate (PT) disposed under the display panel (DP) and including a first area (1A), a second area (2A) positioned in a first direction (DR1) from the first area (1A), and a third area (3A) between the first area (1A) and the second area (2A), wherein holes (PTH) each extending in a second direction (DR2) crossing the first direction (DR1) are defined in the third area (3A); and
a release film (RF) disposed under the support plate (PT), wherein the release film (RF) includes a first sub-layer (L1) and a second sub-layer (L2) disposed between the first sub-layer (L1) and the support plate (PT),
wherein the first sub-layer (L1) includes:
a first side portion (L1a) under the first area (1A) of the support plate (PT);
a second side portion (L1b) under the second area (2A) of the support plate (PT); and
a central portion (L1c) under the third area (3A) of the support plate (PT),
wherein the second sub-layer (L2) includes:
first extension patterns (L2a) disposed on the central portion (L1c) of the first sub-layer (L1), each extending in the first direction (DR1), and spaced apart from each other in the second direction (DR2); and
a second extension pattern (L2b) disposed on the first side portion (L1a) of the first sub-layer (L1) and extending in the second direction (DR2).

12. The display device (DD) of claim 11, wherein:
(i) the first extension patterns (L2a) and the second extension patterns (L2b) directly contact the support plate (PT); and/or
(ii) in a plan view, a size of the release film (RF) is greater than a size of the support plate (PT), and
wherein a length of the second extension pattern (L2b) in the second direction (DR2) is greater than a width of the support plate (PT) in the second direction (DR2); and/or
(iii) a width (W1) of each of the first extension patterns (L2a) in the second direction (DR2) is less than a length (W2) of each of the holes (PTH) of the support plate (PT) in the second direction (DR2).

13. The display device (DD) of any one of claim 11 or claim 12, wherein the release film (RF-2) further includes a masking pattern (MAS) disposed between an end portion of the second extension pattern (L2b) and the support plate (PT),
wherein the masking pattern (MAS) includes a first surface which contacts the end portion of the second extension pattern (L2b) and a second surface opposite to the first surface, and
wherein the second surface of the masking pattern (MAS) is non-adhesive, optionally wherein the masking pattern (MAS) includes a first portion which does not overlap the support plate (PT) in a plan view, and a second portion which overlaps the support plate (PT) in the plan view, and
wherein the second surface of the second portion of the masking pattern (MAS) directly contacts the support plate (PT).

14. The display device (DD) of any one of claims 11 to 13, further comprising:
an adhesive layer (AD6) disposed between the display panel (DP) and the support plate (PT) and overlapping all of the holes (PTH) in a plan view.

15. An electronic device (10) comprising:
a display device (DD) which is configured to display an image, wherein the display device (DD) includes:
a display panel (DP);
a support plate (PT) disposed under the display panel (DP), wherein holes (PTH) each extending in one direction are defined in the support plate (PT); and
an adhesive layer (AD6) disposed between the display panel (DP) and the support plate (PT) and overlapping all of the holes (PTH) of the support plate (PT) in a plan view; and
a processor (12) which provides an image data signal and an input control signal to the display device (DD).
